(19) Europäisches Patentamt
European Patent Office
Office européen des brevets

(11) EP 2 174 363 B1

(12) **EUROPEAN PATENT SPECIFICATION**

(45) Date of publication and mention of the grant of the patent:
**17.08.2016 Bulletin 2016/33**

(21) Application number: **08792026.0**

(22) Date of filing: **25.07.2008**

(51) Int Cl.:
***C09K 11/06*** *(2006.01)* ***H01L 51/52*** *(2006.01)*

(86) International application number:
**PCT/JP2008/063813**

(87) International publication number:
**WO 2009/017210 (05.02.2009 Gazette 2009/06)**

(54) **ORGANIC ELECTROLUMINESCENT DEVICE**

ORGANISCHES ELEKTROLUMINESZENZELEMENT

DISPOSITIF ÉLECTROLUMINESCENT ORGANIQUE

(84) Designated Contracting States:
**AT BE BG CH CY CZ DE DK EE ES FI FR GB GR HR HU IE IS IT LI LT LU LV MC MT NL NO PL PT RO SE SI SK TR**

(30) Priority: **27.07.2007 JP 2007196527**

(43) Date of publication of application:
**14.04.2010 Bulletin 2010/15**

(73) Proprietor: **UDC Ireland Limited**
**Dublin 4 (IE)**

(72) Inventors:
- **KINOSHITA, Masaru**
**Ashigarakami-gun**
**Kanagawa 258-8577 (JP)**
- **TOBISE, Manabu**
**Ashigarakami-gun**
**Kanagawa 258-8577 (JP)**

(74) Representative: **Maiwald Patentanwalts GmbH**
**Elisenhof**
**Elisenstrasse 3**
**80335 München (DE)**

(56) References cited:
**JP-A- 2001 189 193**
**JP-A- 2004 006 102**
**JP-A- 2005 038 672**
**JP-A- 2005 108 665**
**JP-A- 2005 310 547**
**JP-A- 2007 073 943**
**JP-A- 2007 103 493**
**US-A1- 2006 147 615**
**US-A1- 2006 188 746**

Note: Within nine months of the publication of the mention of the grant of the European patent in the European Patent Bulletin, any person may give notice to the European Patent Office of opposition to that patent, in accordance with the Implementing Regulations. Notice of opposition shall not be deemed to have been filed until the opposition fee has been paid. (Art. 99(1) European Patent Convention).



Printed by Jouve, 75001 PARIS (FR)

## Description

BACKGROUND OF THE INVENTION

Field of the Invention

The present invention relates to an organic electroluminescent device.

Description of the Related Art

In recent years, light emitting apparatuses utilizing organic electroluminescent devices (organic EL devices) have been developed. Fig. 6 schematically shows the configuration of an organic EL device 1. On a substrate 2 made of glass or the like, an anode 3, organic EL layers 8 (hole transport layer 4, light emitting layer 5 and electron transport layer 6), a cathode 7 and the like are formed in layers. In the drawing, partitions, insulating films, sealing members and the like are not shown. The two electrodes 3 and 7 are connected to external lines through the lead lines (terminals) of the electrodes. When an electric field is applied to the electrodes, holes and electrons recombine in the light emitting layer 5 in the region sandwiched between the electrodes 3 and 7 to emit light.

In the case of producing a display apparatus capable of color display, for example, an anode is formed on a substrate in stripes, and then patterning is performed using organic EL materials such that organic EL layers corresponding to the colors red (R), green (G) and blue (B), respectively, are shown repeatedly on the anode. Subsequently, a cathode is formed on the organic EL layers, and the terminals (externally connecting terminals) of each of the electrodes are connected to external lines such as control lines, signal lines or the like. Thereby, organic EL devices corresponding to RGB are arranged to form pixels, and thus color display may be carried out.

A material constituting the light emitting layer is required to satisfy conditions such as good luminescence efficiency, good carrier transportability and good film forming properties. The material may be composed only of a light emitting material, or may also be composed of a mixture of a light emitting material and a host material which does not emit light and has charge transportability.

Furthermore, there have been proposed luminescent devices developed under an aim of improving the luminescence efficiency or increasing the service life, by allowing the light emitting layer to have a concentration gradient of the constituent material (see, for example, Japanese Patent Application Laid-Open (JP-A) No. 2001-155862, JPA- No. 2001-189193, JP-A No. 2004-6102 and JP-A No. 2002-313583). However, in practice, an organic EL device achieving improvements in the luminescence efficiency and durability, by allowing the entire light emitting layer to emit light by precisely controlling the carrier balance in the light emitting layer, is not found.

US 2006/147615 A1 and JP 2001 189193 A disclose organic electroluminescent devices having varying concentrations of layer materials.

SUMMARY OF THE INVENTION

The present invention has been achieved in order to address the problems described above, and an object of the invention is to provide an organic electroluminescent device achieving improvements in the luminescence efficiency and durability by emitting light in a wide area of the light emitting layer.

According to an aspect of the invention, there is provided an organic electroluminescent device including an anode, a cathode disposed facing the anode, and an organic layer that is sandwiched between the anode and the cathode and that includes at least a light emitting layer, wherein the light emitting layer comprises a light emitting material having electron transportability, a host material having hole transportability, and an electrically inert material, and the concentration of the light emitting material having electron transportability gradually decreases from a cathode side toward an anode side across the entirety of the thickness of the light emitting layer.

BRIEF DESCRIPTION OF THE DRAWINGS

Fig 1 is a schematic diagram showing an example of the fundamental configuration of an organic EL device according to the present invention.

Fig. 2 is a diagram showing an example of the concentration distribution in the light emitting layer of an organic EL device according to the invention.

Fig. 3 is a diagram showing another example of the concentration distribution in the light emitting layer of an organic EL device according to the invention.

Fig. 4A is a diagram showing the concentration distribution in the light emitting layer of the organic EL device produced in Example 1.

Fig. 4B is a diagram showing the concentration distribution in the light emitting layer of the organic EL device produced in Example 2.

Fig. 4C is a diagram showing the concentration distribution in the light emitting layer of the organic EL device produced in Example 3.

Fig. 5A is a diagram showing the concentration distribution in the light emitting layer of the organic EL device produced in Comparative Example 1.

Fig. 5B is a diagram showing the concentration distribution in the light emitting layer of the organic EL device produced in Comparative Example 2.

Fig. 5 C is a diagram showing the concentration distribution in the light emitting layer of the organic EL device produced in Comparative Example 3.

Fig. 6 is a schematic diagram showing an exemplary configuration of the organic EL device.

Fig. 7 is a diagram showing another example of the concentration distribution in the light emitting layer of an organic EL device according to the invention.

DETAILED DESCRIPTION OF THE EMBODIMENT

Hereinafter, the organic electroluminescent device according to the present invention will be described with reference to the attached drawings.

According to findings of the inventors of the invention, it was experimentally revealed that in an organic EL device using a host material and a light emitting material in the light emitting layer, in the case of a typical configuration using a host material exhibiting hole transportability and a light emitting material exhibiting electron transportability, the luminescence distribution in the light emitting layer is a distribution is inclined toward the electron transport layer (ETL) side. It is expected that this is because the carrier balance in the light emitting layer is in a state of excess of holes and lack of electrons, and such localized light emission causes a decrease in the luminescence efficiency, and deterioration of durability caused by centralization of luminescence load.

With regard to such light emission localized at the ETL side, it is conceived that a host material exhibiting hole transportability and a light emitting material exhibiting electron transportability are used, and a larger number of electrons may be injected into the light emitting layer by increasing the concentration of the light emitting material. However, in a light emitting layer having the light emitting material exhibiting electron transportability at a higher concentration, the luminescence distribution is observed to be inclined toward both the hole transport layer (HTL) side and the electrons transport layer (ETL) side. That is, it is conceived that when the concentration of the light emitting material having electron transportability in the light emitting layer is increased, electrons are injected into the light emitting layer; however, injected electrons migrate up to the interface near the HTL side without contributing to recombination, and consequently, the problem of localized light emission in the vicinity of the interface cannot be solved.

Therefore, the inventors of the invention conducted extensive research and, as a result, they found that when a light emitting material having electron transportability, a host material having hole transportability and an electrically inert material are included in the light emitting layer, and the concentration of the light emitting material having electron transportability is made higher at the cathode side than at the anode side, the luminescence distribution in the light emitting layer approaches a distribution in which light is emitted over the whole span of the layer in the thickness direction, and luminescence efficiency and durability can be thus improved.

Fig. 1 shows an example of the configuration of an organic EL device according to the invention. The organic EL device 10 according to the invention has a structure that an organic layer 16 including at least a light emitting layer is sandwiched between an anode 14 and a cathode 18 that are disposed facing each other on a supporting substrate 12, and a light emitting material having electron transportability, a host material having hole transportability and an electrically inert material are included in the light emitting layer, in which the concentration of the light emitting material having electron transportability gradually decreases from the cathode 18 side toward the anode 14 side.

<Supporting substrate>

The supporting substrate 12 for forming the organic EL device 10 is not particularly limited as long as it has a strength sufficient for supporting the organic EL device 10, light transmission and the like, and any known material may be used. For example, there may be mentioned inorganic materials such as zirconia-stabilized yttrium (YSZ) and glass; and organic materials such as polyesters such as polyethylene terephthalate, polybutylene phthalate and polyethylene naphthalenate, polystyrene, polycarbonates, polyether sulfones, polyallylates, polyimides, polycycloolefins, norbornene resins and poly(chlorotrifluoroethylene).

In the case of using glass for the supporting substrate 12, it is preferable to use non-alkaline glass in order to

reduce the amount of ions eluted from glass. In the case of using soda-lime glass, it is preferable to use a glass provided with a barrier coat of silica or the like.

In the case of using a supporting substrate 12 formed from an organic material, it is preferable to use a material excelling in heat resistance, dimensional stability, solvent resistance, electrical insulating properties and processability. Particularly, in the case of using a plastic supporting substrate 12, it is preferable to provide a moisture permeation blocking layer or a gas barrier layer on one surface or both surfaces of the supporting substrate 12. As for the material for the moisture permeation blocking layer or gas barrier layer, an inorganic material such as silicon nitride or silicon oxide may be suitably used. The moisture permeation blocking layer or gas barrier layer may be formed by, for example, high frequency sputtering or the like.

Furthermore, in the case of using a thermoplastic supporting substrate, a hardcoat layer, an undercoat layer and the like may be further provided as necessary.

The shape, structure, size and the like of the supporting substrate 12 are not particularly limited, and may be appropriately selected in accordance with the use, purpose or the like of the organic EL display device 10. In general, the shape of the supporting substrate 12 is preferably plate-shaped from the viewpoints of handlability, easiness of formation of the organic EL device, and the like. The structure of the supporting substrate 12 may be a single layer structure, or may be a laminated structure. The supporting substrate 12 may also be composed of a single member, or may also be composed of two or more members.

In addition, the emitting apparatuses based on the organic EL device are classfied into a bottom emission type in which the light emitted from the light emitting layer is extracted through the supporting substrate 12 side, and a top emission type in which the light is extracted through the opposite side of the supporting substrate 12. The invention may employ any of the two types. In the case of producing a top emission type organic EL emitting apparatus, since it is not necessary to extract the emitted light through the supporting substrate 12 side, for example, a metal substrate made of stainless steel, Fe, Al, Ni, Co, Cu or an alloy thereof, or a silicon substrate may be used. A supporting substrate made of metal has high strength even with a small thickness, and has high gas barrier properties against the moisture or oxygen in the atmosphere. In the case of using a supporting substrate made of metal, it is required to provide an insulating film to secure electrical insulating properties between the supporting substrate 12 and a lower electrode 14.

<Organic EL device>

The organic EL device 10 according to the invention may employ, for example, a layer configuration as shown in the following, but the layer configuration is not limited to these, and may be appropriately determined in accordance with the purpose or the like.

- Anode/light emitting layer/cathode
- Anode/hole transport layer/light emitting layer/electron transport layer/cathode
- Anode/hole transport layer/light emitting layer/blocking layer/electron transport layer/cathode
- Anode/hole transport layer/light emitting layer/blocking layer/electron transport layer/electron injection layer/cathode
- Anode/hole injection layer/hole transport layer/light emitting layer/blocking layer/electron transport layer/cathode
- Anode/hole injection layer/hole transport layer/light emitting layer/blocking layer/electron transport layer/electron injection layer/cathode

Usually, the electrode on the supporting substrate 12 side (lower electrode) 14 is made into an anode, while the electrode on the sealing substrate (not depicted) side (upper electrode) 18 is made into a cathode. However, it is also possible to make the lower electrode as the cathode, and the upper electrode as the anode. In the following description, there will be described a configuration having the members sequentially formed starting from the anode 14 on the supporting substrate 12, but it is also possible to form the assembly in the reverse manner, starting from the cathode on the supporting substrate 12.

- Anode -

The anode 14 is not particularly limited in the shape, structure, size or the like, as long as it may function as an electrode for supplying holes to the organic EL layer 16, and the component material may be appropriately selected from known electrode materials in accordance with the use, purpose or the like of the organic EL device 10.

As for the material constituting the anode 14, for example, metals, alloys, metal oxides, electrically conductive compounds or mixtures thereof, may be suitably mentioned. Specific examples thereof include electrically conductive metal oxides such as tin oxide doped with antimony or fluorine (ATO, FTO), tin oxide, zinc oxide, indium oxide, indium-tin oxide (ITO) and indium zinc oxide (IZO); metals such as gold, silver, chromium and nickel; mixtures or laminates of

these metals and electrically conductive metal oxides; inorganic conductive materials such as copper iodide and copper sulfide; organic conductive materials polyaniline, polythiophene and polypyrrole; and laminates of these materials and ITO; and the like. Among these, preferred are the electrically conductive metal oxides, and particularly preferably, ITO is preferred from the viewpoints of productivity, high conductivity, transparency and the like.

As for the method for forming the anode 14, for example, there may be mentioned wet methods such as printing methods and coating methods; physical methods such as vacuum deposition, sputtering and ion plating; and chemical methods such as CVD and plasma CVD. The method may be appropriately selected while considering the conformability of the material for constituting the anode 14, or the like. For example, in the case of using ITO as the material for anode, the anode 14 may be formed by direct current or high frequency sputtering, vacuum deposition, ion plating or the like.

The position for forming the anode 14 may be appropriately selected in accordance with the use, purpose or the like of the organic EL device 10, and the anode may be formed over the entire surface of the supporting substrate 12, or may be formed over a part of the surface.

During the formation of the anode 14, patterning may be carried out by chemical etching based on photolithography or the like, or may be carried out by physical etching utilizing laser or the like. Furthermore, vacuum deposition, sputtering or the like may be performed with superimposing a mask on the anode, or it is also acceptable to perform a lift-off method or a printing method.

The thickness of the anode 14 is preferably appropriately selected according to the material constituting the anode 14 or the like, but typically, the thickness is about 10 nm to 50 μm, and preferably 50 nm to 20 μm.

The resistance value of the anode 14 is preferably $10^3$ Ω/□ or less, and more preferably $10^2$ Ω/□ or less, in order to securely supply holes to the organic EL layer 16.

In the case of extracting light from the anode side, the light transmittance is preferably 60% or higher, and more preferably 70% or higher. Detailed descriptions on transparent anode may be found in "New Development of Transparent Electrode Films," supervised by Yutaka Sawada, CMC Publishing Co., Ltd. (1999), and the matters described therein are also applicable to the invention. For example, in the case of using a plastic supporting substrate having low heat resistance, a transparent anode produced by forming a film using ITO or IZO at a low temperature of 150°C or lower, is preferred.

- Organic layer -

The organic layer (organic EL layer) 16 is sandwiched between the anode 14 and the cathode 18, and has a configuration including at least a light emitting layer. As for layers constituting the organic layer 16 other than the light emitting layer, as previously described, various layers such as a hole transport layer, an electron transport layer, a charge blocking layer, a hole injection layer and an electron injection layer may be mentioned. As a preferred layer configuration, there may be mentioned an embodiment in which, from the anode side, a hole transport layer, a light emitting layer and an electron transport layer are formed in this order, and the configuration may further have, for example, a charge blocking layer or the like, between the hole transport layer and the light emitting layer, or between the light emitting layer and the electron transport layer. A hole injection layer may be provided between the anode 14 and the hole transport layer, or an electron injection layer may be provided between the cathode 18 and the electron transport layer. Furthermore, each of the layers may be divided into plural secondary layers.

Each layer constituting the organic layer 16 may be suitably formed by any of dry film forming methods such as deposition and sputtering, transfer methods, printing methods, and the like.

- Light emitting layer -

The light emitting layer is a layer having a function of, when an electric field is applied, receiving holes from the anode 14, the hole injection layer or the hole transport layer, receiving electrons from the cathode 18, the electron injection layer or the electron transport layer, and providing a site for recombination of the holes and the electrons to emit light.

The organic EL device 10 according to the invention contains, irrespective of which layer configuration being taken, a light emitting material having electron transportability, a host material having hole transportability, and an electrically inert material, and the concentration of the light emitting material having electron transportability is set to be higher at the cathode side than at the anode side. Here, the light emitting material having electron transportability is a material which has higher electron transportability than hole transportability, and emits light, while the host material having hole transportability is a material which has higher hole transportability than electron transportability, and does not emit light. The electrically inert material is a material which does not have charge transportability (electron transportability and hole transportability), and does not emit light, and is also referred to as binder.

Fig. 2 shows an example (first embodiment) of the concentration distribution in the light emitting layer of an organic EL device according to the invention. This light emitting layer is composed of a light emitting material having

electron transportability, a host material having hole transportability, and an electrically inert material (binder), and the concentration of the light emitting material having electron transportability gradually decreases from the cathode side toward the anode side. On the other hand, the concentration of the host material having hole transportability gradually decreases from the anode side toward the cathode side, and the concentration of the binder is constant along the thickness direction.

When a light emitting layer having such concentration distribution is used, the luminescence distribution in the light emitting layer approaches a distribution in which light is emitted over the whole span of the layer in the thickness direction, and the luminescence efficiency and durability may be improved. One of the reasons why the luminescence distribution approaches a distribution in which light is emitted over the whole span of the layer in the thickness direction, is conceived to be because, since the concentration of the light emitting material having electron transportability is higher at the cathode side than at the anode side, the electrons injected from the cathode side into the light emitting layer are restrained from migrating as the electrons advance toward the anode side, and thus the electrons undergo recombination with holes even in the central part of the light emitting layer, resulting in light emission. Furthermore, the light emitting layer includes an electrically inert material (binder). Although this binder is a material having no charge transportability, the binder functions as a dispersant of the light emitting material, and also functions to suppress the hole transportability provided by the host material. Therefore, it is also conceived that the migration of the holes injected from the anode side into the light emitting layer is suppressed, and the recombination with electrons may easily occur even at the anode side and in the central part, before the holes migrate toward the cathode side of the light emitting layer. As such, the light emitting layer includes a light emitting material having electron transportability, a host material having hole transportability and an electrically inert material, and mainly, by a synergistic effect based on the fact that the concentration of the light emitting material having electron transportability in the light emitting layer gradually decreases from the cathode side toward the anode side, and a binder is included in the light emitting layer, it becomes easier for the electrons and the holes to recombine in the vicinity of the end parts of the light emitting layer, as well as in the vicinity of the central part of the light emitting layer. Thus, light emission may be achieved efficiently in the entirety of the light emitting layer. Thereby, the luminescence distribution inclined toward the cathode side is greatly improved, thus luminescence efficiency being enhanced, and also centralization of the luminescence load is prevented, thus durability being enhanced.

Fig. 3 shows another example (second embodiment) of the concentration distribution in the light emitting layer of an organic EL device according to the invention. This light emitting layer also includes a light emitting material having electron transportability, a host material having hole transportability and an electrically inert material, and the concentration of the light emitting material having electron transportability in the light emitting layer gradually decreases from the cathode side toward the anode side, while the concentration of the binder also gradually decreases from the cathode side toward the anode side. As such, when the concentration of the light emitting material having electron transportability and the concentration of the binder in the light emitting layer gradually decrease from the cathode side toward the anode side, the effect exerted by the binder is small at the anode side and is large at the cathode side. Thereby, the holes injected from the anode side into the light emitting layer transfer slower as they go closer to the anode side from the cathode side, and thus localized light emission is further suppressed, while the luminescence efficiency and durability may be further improved.

The concentration distributions of the various materials constituting the light emitting layer are not particularly limited, as long as the concentration of the light emitting material having electron transportability gradually decreases from the cathode side toward the anode side. However, for example, if the concentration of the light emitting material having electron transportability is too low at the cathode side of the light emitting layer, electrons are not injected sufficiently into the light emitting layer, and on the contrast, if the concentration is too high, concentration quenching or associated light emission may occur, and there is a risk for having a decrease in efficiency or deterioration of chromaticity. Furthermore, if the concentration of the light emitting material having electron transportability or the concentration of the binder is high at the anode side in the light emitting layer, and the concentration of the host material having hole transportability is too low, holes are not injected sufficiently into the light emitting layer, and there is a risk for having a decrease in the luminescence intensity.

From the viewpoints as described above, the concentration (% by mass) of the light emitting material having electron transportability in the region near the interface at the cathode side of the light emitting layer is preferably 5 to 100%, more preferably 10 to 80%, and particularly preferably 15 to 70%. On the other hand, the concentration (% by mass) of the light emitting material having electron transportability in the region near the interface at the anode side of the light emitting layer is preferably 0 to 10%, more preferably 0 to 7%, and particularly preferably 0 to 5%.

It is also preferable that the concentration of the light emitting material having electron transportability in the region near the interface at the anode side of the light emitting layer is from 0% by mass to 50% by mass, and more preferably from 0% by mass to 20% by mass, relative to the concentration of the light emitting material having electron transportability in the region near the interface at the cathode side of the light emitting layer.

Additionally, in the present specification, the term "region near the interface at the cathode side of the light emitting layer" is defined to mean a region extending to a thickness of 10% of the total thickness of the light emitting

layer from the interface at the cathode side of the light emitting layer, while the term "region near the interface at the anode side of the light emitting layer" is defined to mean a region extending to a thickness of 10% of the total thickness of the light emitting layer from the interface at the anode side of the light emitting layer. Further, the concentration in the region is defined to mean the average concentration throughout the region. The concentrations of the various materials in the "region near the interface at the cathode side (anode side) of the light emitting layer" can be measured according to a method such as time-of-flight secondary ion mass spectrometry (TOF-SIMS), or etching/X-ray photoelectron spectroscopy (XPS/ESCA).

The light emitting material having electron transportability is preferably contained in the light emitting layer in an amount of 5 to 50% by mass, and more preferably in an amount of 10 to 30% by mass, from the viewpoints of obtaining sufficient luminescence intensity, preventing concentration quenching, and the like.

It is preferable that the concentration of the host material having hole transportability in the light emitting layer gradually decreases from the anode side toward the cathode side, contrary to the concentration of the light emitting material having electron transportability. The concentration (% by mass) of the host material having hole transportability in the region near the interface at the cathode side of the light emitting layer is preferably 0 to 10%, more preferably 0 to 7%, and particularly preferably 0 to 5%. On the other hand, the concentration (% by mass) of the host material having hole transportability in the region near the interface at the anode side of the light emitting layer is preferably 5 to 100%, more preferably 10 to 80%, and particularly preferably 15 to 70%.

The host material having hole transportability is preferably contained in the light emitting layer in an amount of 5 to 90% by mass, and more preferably in an amount of 10 to 70% by mass, from the viewpoint of carrier balance or the like.

Furthermore, the concentration of the electrically inert material (binder) in the light emitting layer is preferably constant or gradually decreases from the cathode side toward the anode side, and more preferably gradually decreases from the cathode side toward the anode side, similarly to the concentration of the light emitting material having electron transportability, from the viewpoints described above. The concentration (% by mass) of the electrically inert material (binder) in the region near the interface at the cathode side of the light emitting layer is preferably 0 to 95%, more preferably 10 to 90%, and particularly preferably 20 to 85%. On the other hand, the concentration (% by mass) of the electrically inert material (binder) in the region near the interface at the anode side of the light emitting layer is preferably 0 to 95%, more preferably 0 to 90%, and particularly preferably 0 to 85%.

The electrically inert material (binder) is preferably contained in the light emitting layer in an amount of 1 to 90% by mass, and more preferably in an amount of 10 to 80% by mass, in order to sufficiently obtain the effect derived from the binder.

The method of gradually decreasing the concentration of the light emitting material having electron transportability in the light emitting layer is not particularly limited and, for example, the concentration may be gradually decreased from the cathode side toward the anode side continuously with a linear or a curved gradient of decrease, or may be gradually decreased in a stepwise manner. Further, for example, in the case of a light emitting layer having a concentration gradient that decreases within the light emitting layer, even if there are regions within the layer where the concentration increases locally, as long as the concentration gradient decreases overall, the light emitting layer is within the intended scope of the present application. In addition, from the viewpoints of avoiding a high luminescence load due to localized light emission, and more uniformly emitting light over the entire span of the light emitting layer, it is preferable for the light emitting material having electron transportability in the light emitting layer has a concentration that gradually decreases continuously with a linear gradient of decrease from the cathode side toward the anode side, as shown in Fig. 2 and Fig. 3.

Also, in the case where the host material having hole transportability or the electrically inert material in the light emitting layer has a concentration distribution, it is preferable that the concentration gradually decreases or increases continuously with a linear or a curved gradient of decrease or increase along the thickness direction of the light emitting layer, or that the concentration gradually decreases or gradually increase in a stepwise manner.

Next, various materials constituting the light emitting layer will be described in more detail.

(A) Light emitting material having electron transportability

The light emitting material in the light emitting layer according to the invention may be a fluorescent light emitting material or a phosphorescent light emitting material, as long as it is capable of transporting electrons.

(a) Phosphorescent light emitting material

As for the phosphorescent light emitting material, generally a complex containing a transition metal atom or a lanthanoid atom may be mentioned.

Examples of the transition metal atom include, preferably, ruthenium, rhodium, palladium, tungsten, rhenium, osmium, iridium and platinum, and more preferably rhenium, iridium and platinum, while more preferred are iridium and

platinum.

Examples of the lanthanoid atom include lanthanum, cerium, praseodymium, neodymium, samarium, europium, gadolinium, terbium, dysprosium, holmium, erbium, thulium, ytterbium and lutetium. Among these lanthanoid atoms, neodymium, europium and gadolinium are preferred.

As for the ligand of the complex, for example, there may be mentioned the ligands described in G. Wilkinson et al., "Comprehensive Coordination Chemistry," Pergamon Press (1987); H. Yersin, "Photochemistry and Photophysics of Coordination Compounds," Springer Verlag (1987); Yamamoto Akio, "Organometallic Chemistry - Fundamentals and Applications," Shokabo Publishing Co., Ltd. (1982); and the like.

Specific examples of the ligand include, preferably, a halogen ligand (preferably, a chlorine ligand), an aromatic carbocyclic ligand (for example, cyclopentadienyl anion, benzene anion, naphthyl anion or the like), a nitrogen-containing heterocyclic ligand (for example, phenylpyridine, benzoquinoline, quinolinol, bipyridyl, phenanthroline or the like), a diketone ligand (for example, acetylacetone or the like), a carboxylic acid ligand (for example, an acetic acid ligand or the like), an alcoholate ligand (for example, a phenolate ligand or the like), a carbon monoxide ligand, an isonitrile ligand, and a cyano ligand, and more preferred is a nitrogen-containing heterocyclic ligand.

The complex may have one transition metal atom in the compound, or may form a so-called multinuclear complex having two or more metal atoms. The ligand may also simultaneously contain different metal atom species.

Among these, specific examples of the light emitting material include the phosphorescent emitting compounds described in patent publications, for example, US Patent No. 6,303,238 B1, USPNo. 6,097,147, WO 00/57676, WO 00/70655, WO 01/08230, WO 01/39234 A2, WO 01/41512 A1, WO 02/02714 A2, WO 02/15645 A1, WO 02/44189 A1, JP-ANo. 2001-247859, Japanese Patent Application No. 2000-33561, JP-ANo. 2002-117978, JP-ANo. 2002-225352, JP-A No. 2002-235076, Japanese Patent Application No. 2001-239281, JP-ANo. 2002-170684, EP No. 1211257, JP-A No. 2002-226495, JP-A No. 2002-234894, JP-A No. 2001-247859, JP-ANo. 2001-298470, JP-ANo. 2002-173674, JP-ANo. 2002-203678, JP-ANo. 2002-203679, JP-A No. 2004-357791, Japanese Patent Application No. 2005-75340, Japanese Patent Application No. 2005-75341, and the like.

(b) Fluorescent light emitting material

Examples of the fluorescent emitting dopant include, in general, benzoxazole, benzimidazole, benzothiazole, styrylbenzene, polyphenyl, diphenylbutadiene, tetraphenylbutadiene, naphthalimide, coumarin, pyrane, perinone, oxadiazole, aldazine, pyralidine, cyclopentadiene, bis-styrylanthracene, quinacridone, pyrrolopyridine, thiadiazolopyridine, cyclopentadiene, styrylamine, aromatic dimethylidene compounds, fused polycyclic aromatic compounds (anthracene, phenanthroline, pyrene, perylene, rubrene, pentacene or the like), various metal complexes represented by metal complexes of 8-quinolinol, pyrromethene complexes or rare earth complexes, polymer compounds such as polythiophene, polyphenylene and polyphenylenevinylene, organic silanes, and the derivatives thereof.

The light emitting material having electron transportability is preferably a light emitting material having electron transportability having an electron affinity (Ea) of 2.5 eV or more and 3.5 eV or less, and an ionization potential (Ip) of 5.7 eV or more and 7.0 eV or less.

Specifically, ruthenium, rhodium, palladium, tungsten, rhenium, osmium, iridium, platinum, lanthanum, cerium, praseodymium, neodymium, samarium, europium, gadolinium, terbium, dysprosium, holmium, erbium, thulium, ytterbium and lutetium complexes may be mentioned. Ruthenium, rhodium, palladium and platinum complexes are more preferred, and platinum complexes are most preferred.

The platinum complexes will be shown in the following as an example, but the invention is not to be limited to these.

Compound (1)

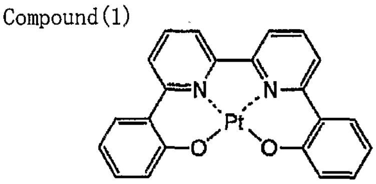

Compound (6)

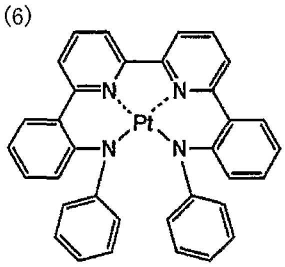

Compound (2)

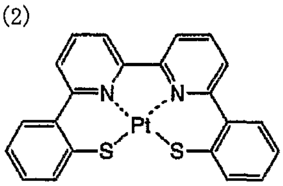

Compound (12)

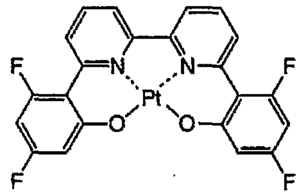

Compound (3)

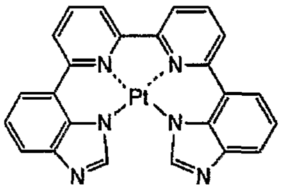

Compound (4)

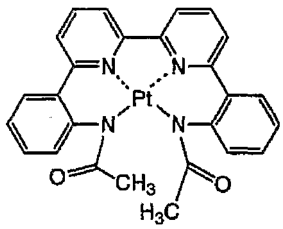

Compound (5)

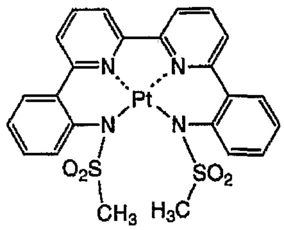

Compound (13)

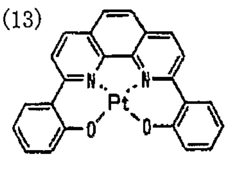

Compound (18)

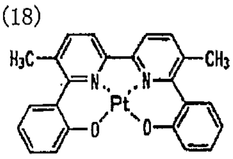

Compound (14)

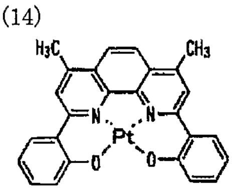

Compound (19)

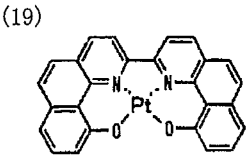

Compound (15)

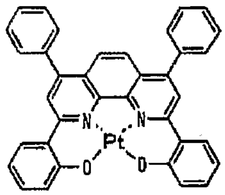

Compound (16)

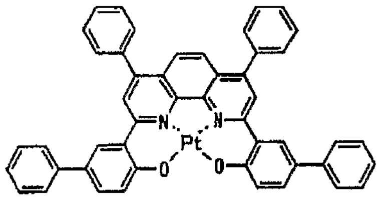

Compound (17)

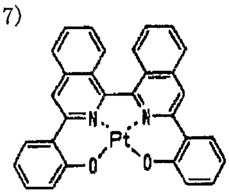

Compound (20)

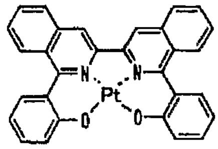

Compound (21)

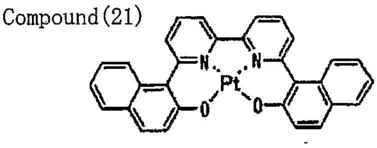

Compound (22)

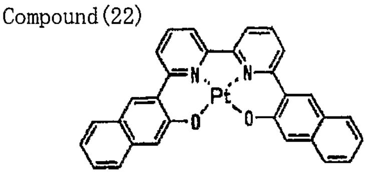

Compound (23)

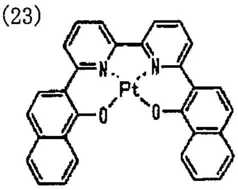

Compound (24)

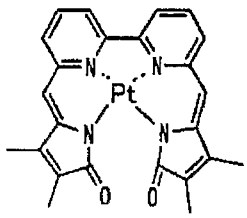

Compound (25)

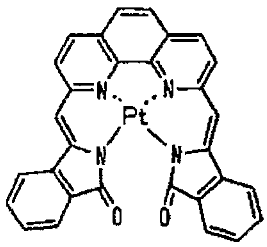

Compound (29)

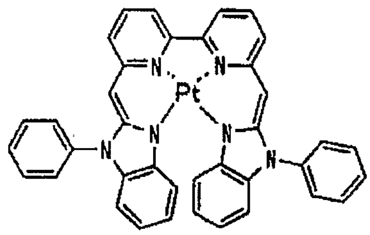

Compound (30)

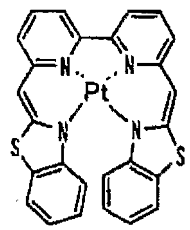

Compound (26)

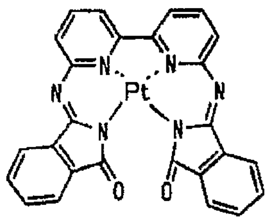

Compound (31)

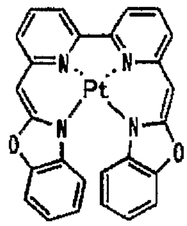

Compound (27)

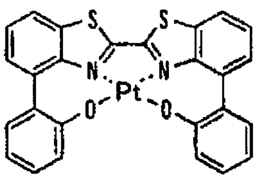

Compound (32)

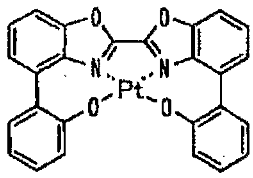

Compound (28)

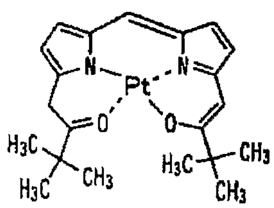

Compound (33)

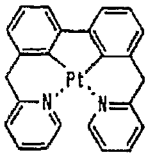

Compound (34)

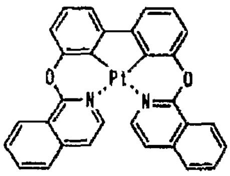

Compound (35)

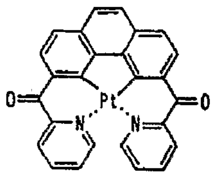

Compound (36)

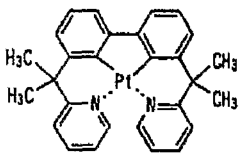

Compound (37)

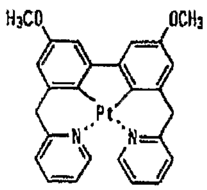

Compound (38)

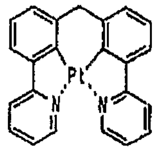

Compound (39)

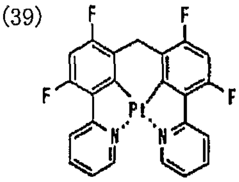

Compound (40)

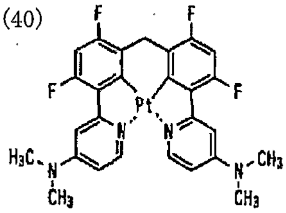

Compound (41)

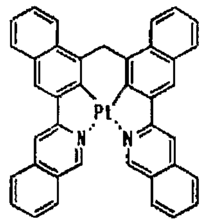

Compound (42)

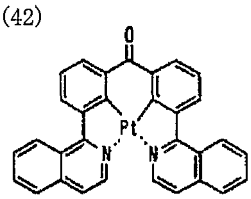

Compound (43)

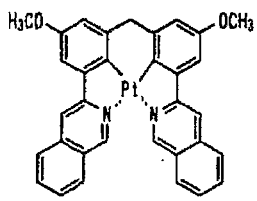

Compound (44)

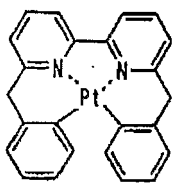

Compound (45)

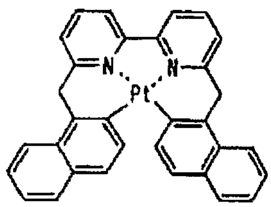

Compound (46)

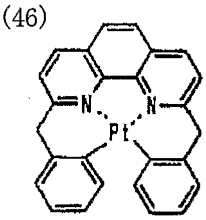

Compound (47)

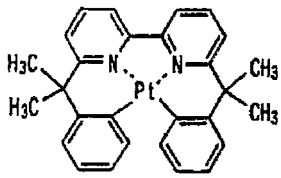

Compound (48)

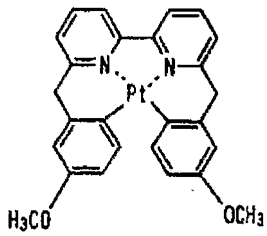

Compound (49)

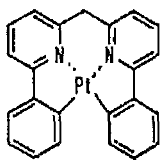

Compound (55)

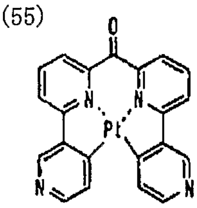

Compound (50)

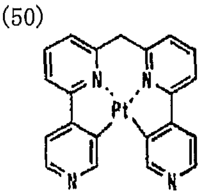

Compound (56)

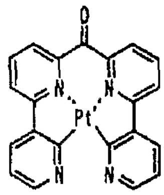

Compound (51)

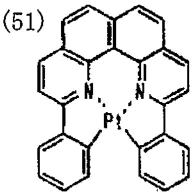

Compound (57)

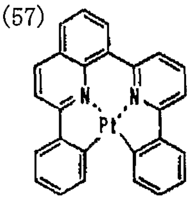

Compound (52)

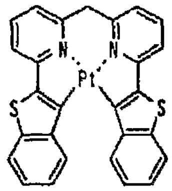

Compound (58)

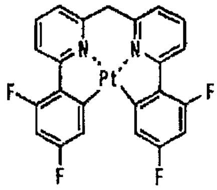

Compound (59)

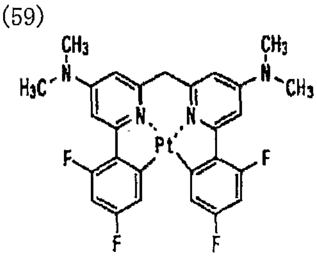

Compound (53)

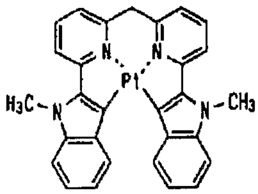

Compound (60)

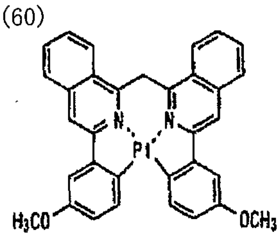

Compound (54)

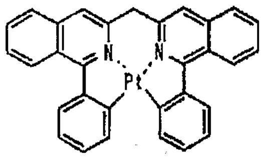

Compound (61)

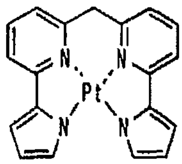

Compound (63)

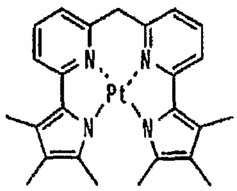

Compound (62)

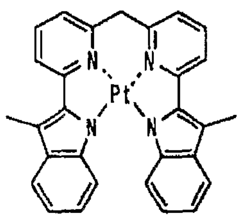

Compound (64)

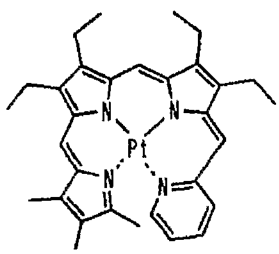

Compound (65)

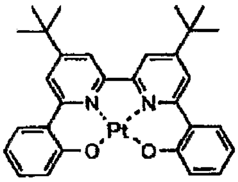

Compound (66)

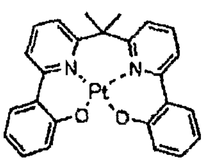

Compound (72)

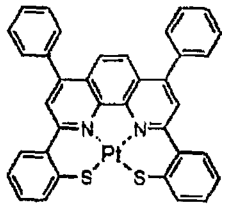

Compound (67)

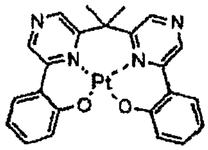

Compound (73)

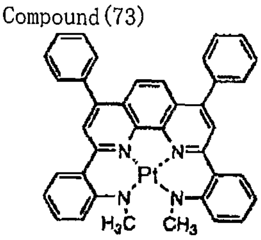

Compound (68)

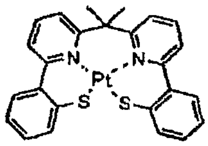

Compound (74)

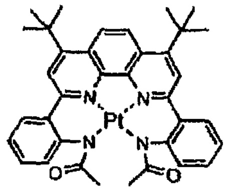

Compound (69)

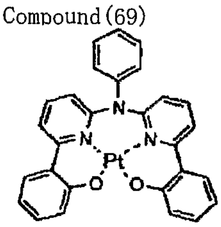

Compound (75)

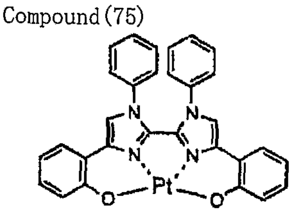

Compound (70)

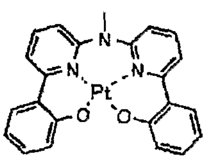

Compound (76)

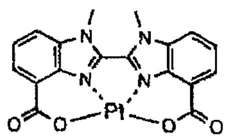

Compound (71)

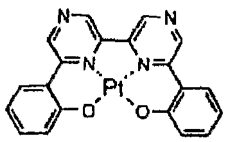

Compound (77)

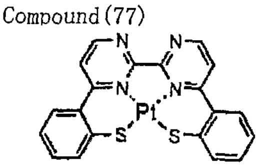

Compound (78)

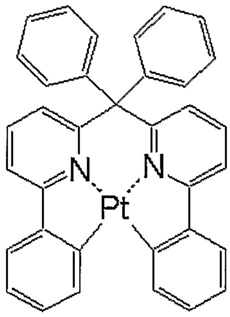

Compound (81)

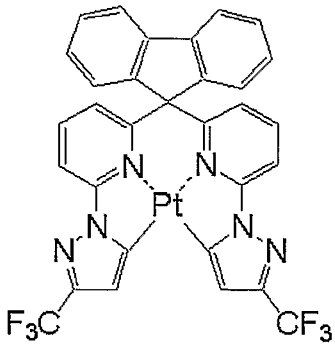

Compound (79)

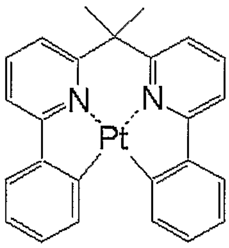

Compound (82)

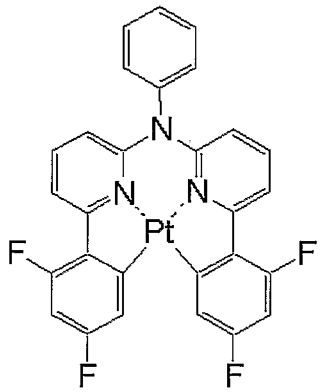

Compound (80)

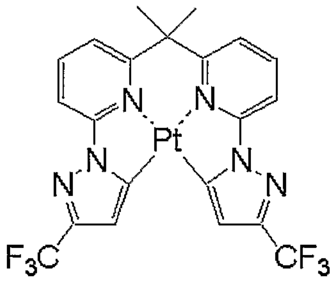

Compound (83)

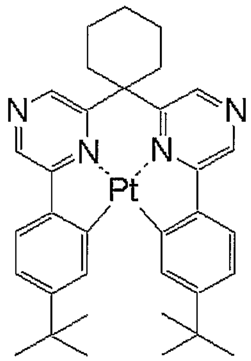

Compound (84)

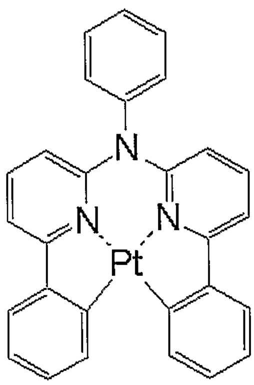

Compound (87)

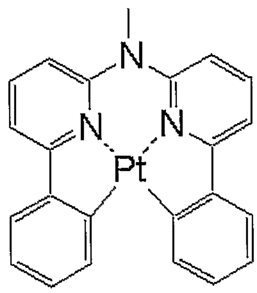

Compound (85)

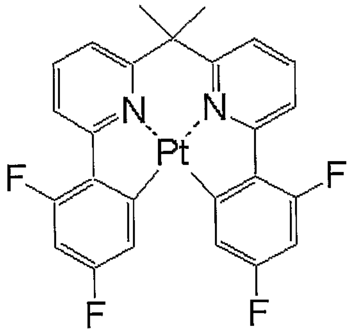

Compound (86)

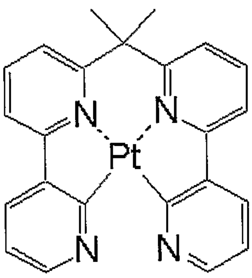

Compound (90)

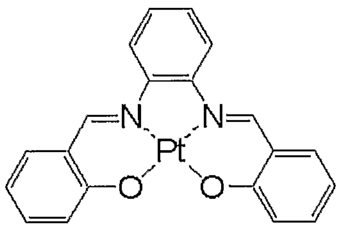

Compound (91)

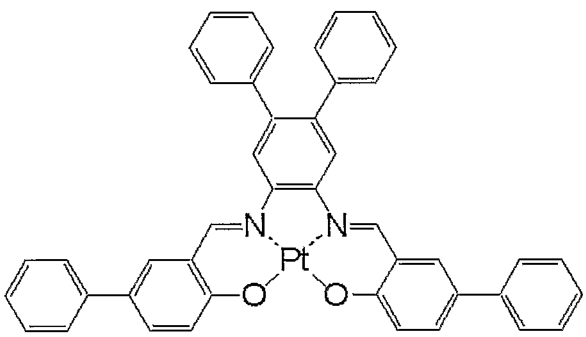

Compound (92)

Compound (88)

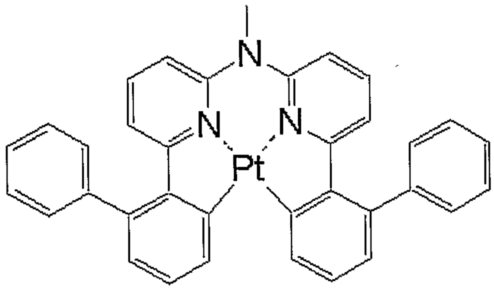

Compound (89)

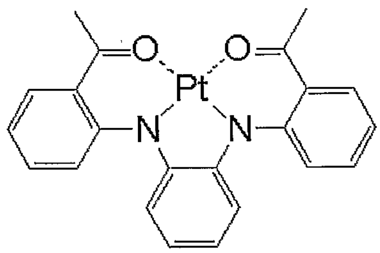

Compound (93)

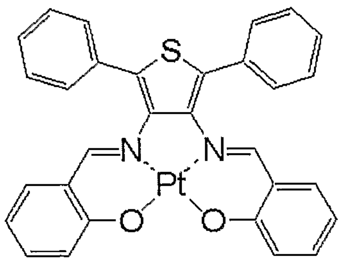

Compound (94)

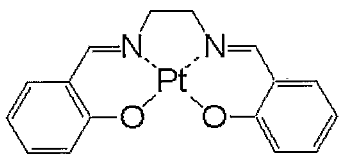

Compound (95)

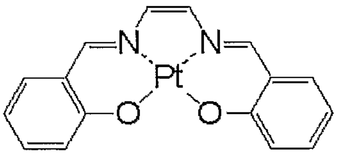

Compound (96)

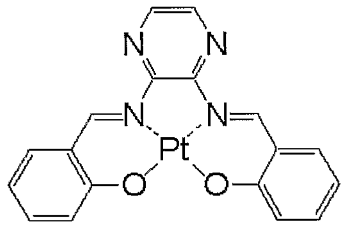

Compound (98)

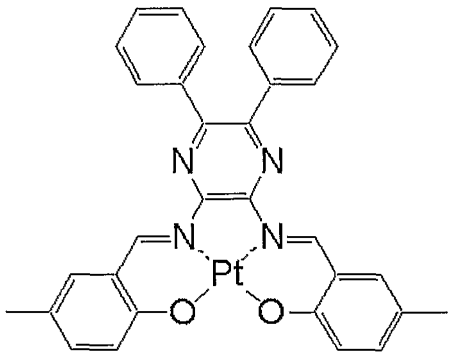

Compound (97)

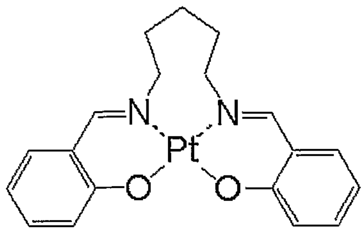

Compound (99)

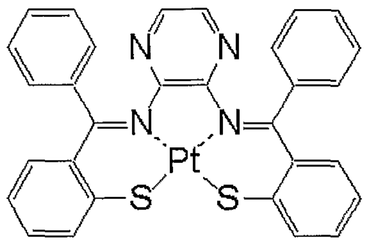

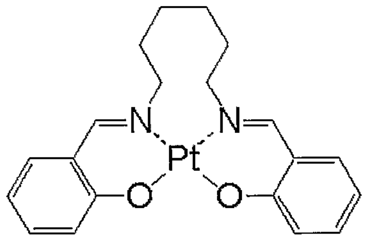

Furthermore, a phosphorescent device utilizing a phosphorescent light emitting material as the light emitting material is generally prone to produce a so-called roll-off phenomenon, in which the efficiency is decreased in high current ranges. In particular, with respect to the luminescence distribution in the light emitting layer in a blue phosphorescent organic EL device having a typical configuration utilizing a host material exhibiting hole transportability and a blue phosphorescent light emitting material exhibiting electron transportability, the carrier balance in the light emitting layer is prone to be in a state of excess of holes and lack of electrons. However, since the organic EL device according to the invention is in a state that the carrier balance of holes and electrons in the light emitting layer approaches uniformity, the electrons and the holes may recombine and emit light in the entire light emitting layer. Therefore, the organic EL device according to the invention is such that even when a phosphorescent light emitting material is used as the light emitting material, to thus obtain a phosphorescent device that is prone to produce the roll-off phenomenon, the decrease in luminescence efficiency in high current ranges may be effectively prevented. Particularly, when the organic EL device of the invention is applied to a blue phosphorescent organic EL device in which the peak wavelength of the luminescence spectrum lies between 430 nm and 480 nm, remarkable effects may be obtained.

(B) Host material having hole transportability

For the host material constituting the light emitting layer in the invention, a host material having hole transportability is used.

Such host material having hole transportability has an ionization potential, Ip, of preferably 5.1 eV or more and 6.4 eV or less, more preferably 5.4 eV or more and 6.2 eV or less, and even more preferably 5.6 eV or more and 6.0 eV or less, from the viewpoint of improving durability and lowering the driving voltage. The host material also has an electron affinity, Ea, of preferably 1.2 eV or more and 3.1 eV or less, more preferably 1.4 eV or more and 3.0 eV or less,

and even more preferably 1.8 eV or more and 2.8 eV or less, from the viewpoint of improving durability and lowering the driving voltage.

Specifically, for example, the following materials may be mentioned.

There may be mentioned pyrrole, carbazole, azacarbazole, indole, azaindole, pyrazole, imidazole, polyarylalkane, pyrazoline, pyrazolone, phenylenediamine, arylamine, amino-substituted chalcone, styrylanthracene, fluorenone, hydrazone, stilbene, silazane, aromatic tertiary amine compounds, styrylamine compounds, aromatic dimethylidene compounds, porphyrin compounds, polysilane compounds, poly(N-vinylcarbazole), aniline copolymers, thiophene oligomers, electrically conductive high molecular weight oligomers such as polythiophene, organic silanes, carbon membranes, and derivatives thereof.

Among them, carbazole derivatives, indole derivatives, aromatic tertiary amine compounds, and thiophene derivatives are preferred, and particularly, those having a plurality of a carbazole skeleton and/or an indole skeleton and/or an aromatic tertiary amine skeleton in the molecule are preferred. Furthermore, those having a carbazole skeleton and/or an indole skeleton are preferred.

Examples of specific compounds as such host material having hole transportability include the following, but are not limited to these.

H-1

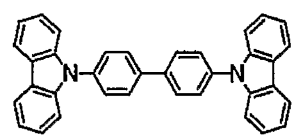

H-2

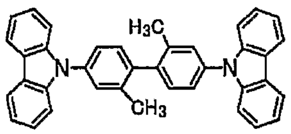

H-3

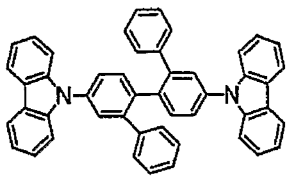

H-4

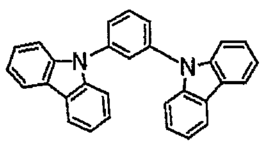

H-5

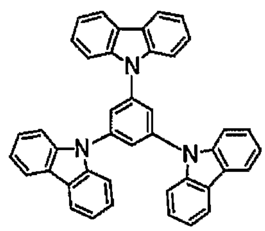

H-6

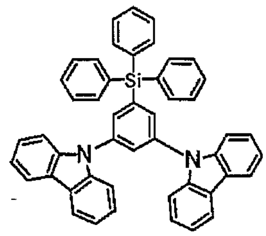

H-7

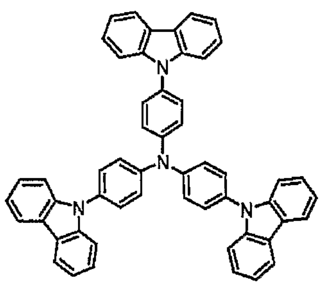

H-8

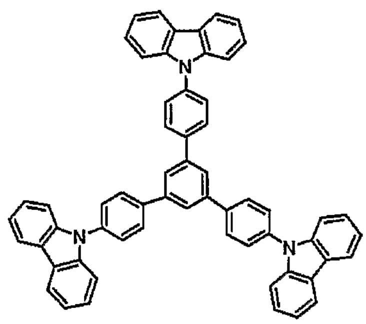

H-9

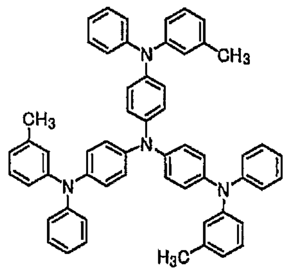

H-10

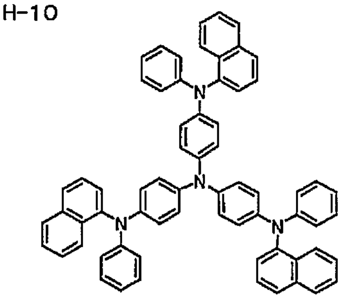

H-11

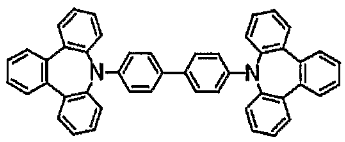

H-12

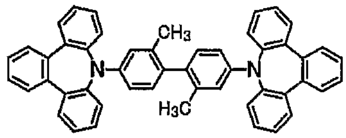

H-13

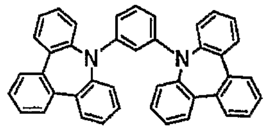

H-14

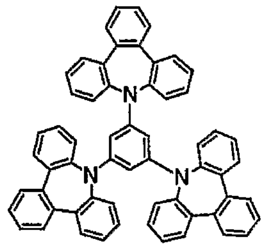

H-15

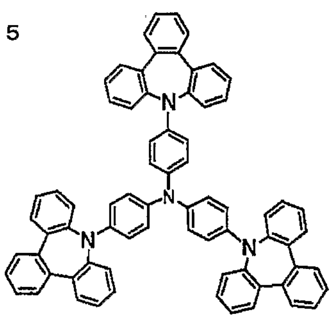

H-16

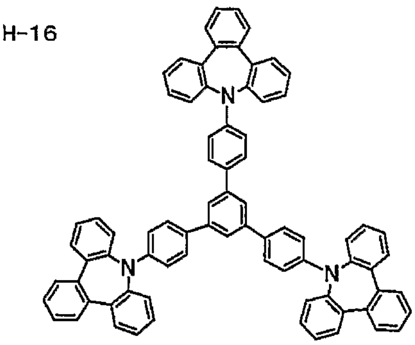

H-17

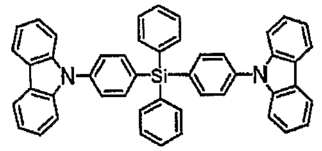

H-18

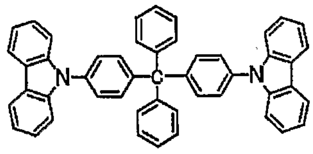

H-19

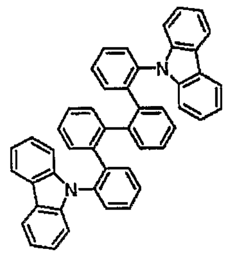

H-20

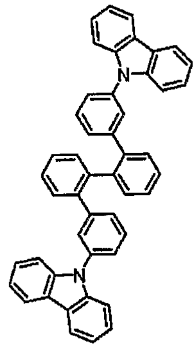

H-21

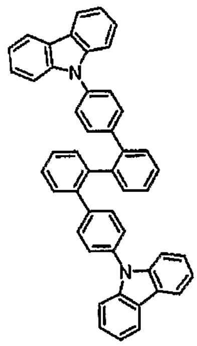

H-22

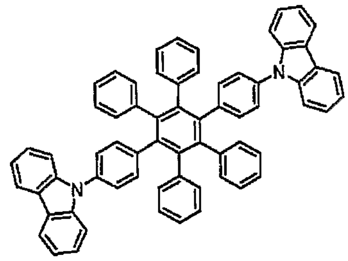

H-23

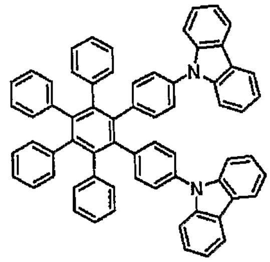

H－２４

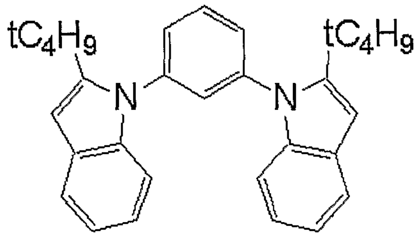

H－２５

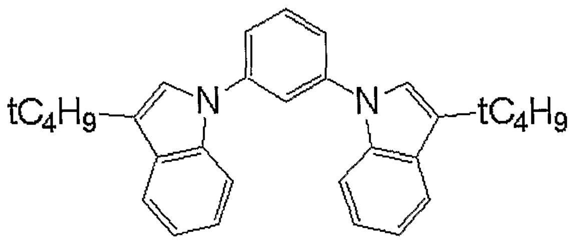

H－２６

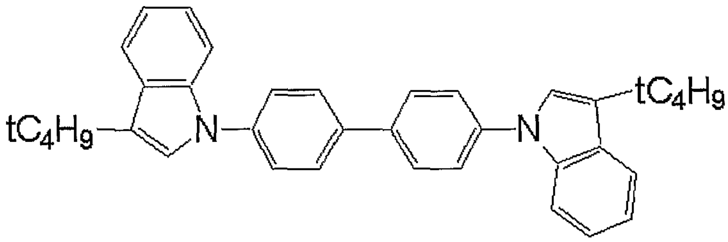

(C) Electrically inert material (binder)

As for the electrically inert material included in the light emitting layer, any of an organic material and an inorganic material may be used.

The electrically inert material included in the light emitting layer is preferably an organic material having an energy difference Eg between the highest occupied molecular orbital and the lowest unoccupied molecular orbital of 4.0 eV or more, and more preferably is a material having an Eg of 4.1 eV or more (a) and 5.0 eV or less, and more preferably 4.2 eV or more and 5.0 eV or less. When the Eg is 4.0 eV or more, holes and/or electrons are prevented from penetrating into the inert material, and the carrier mobility may be appropriately maintained, thus the luminescence efficiency and durability being further increased.

An electrically inert organic material may be suitably selected from aromatic hydrocarbon compounds, and as one of such compound families, compounds represented by the following formula (1) may be mentioned.

Formula (1) $L\text{-}(Ar)_m$

In the formula (1), Ar represents a group represented by the following formula (2); L represents a trivalent or higher valent benzene skeleton; and m represents an integer of 3 or greater.

Formula(2)

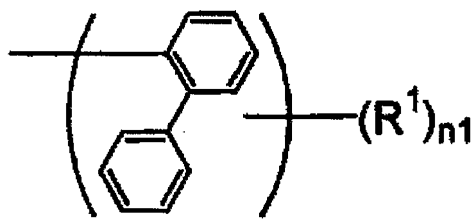

In the formula (2), $R^1$ represents a substituent, and when $R^1$ is present in plurality, each $R^1$ may be identical with or different from another $R^1$; and n1 represents an integer from 0 to 9.

Another preferred compound family includes compounds represented by the following formula (3).

Formula(3)

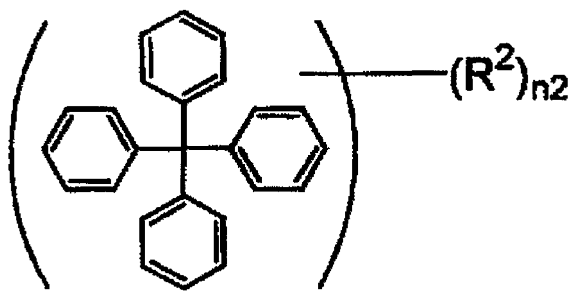

In the formula (3), $R^2$ represents a substituent, and when $R^2$ is present in plurality, each $R^2$ may be identical with or different from another $R^2$; and n2 represents an integer from 0 to 20.

First, the formula (1) will be described in detail.

L included in the formula (1) represents a trivalent or higher valent benzene skeleton. Ar represents a group represented by the formula (2), and m represents an integer of 3 or greater. m is preferably 3 or more and 6 or less, and more preferably 3 or 4.

Next, the group represented by the formula (2) will be described.

$R^1$ included in the formula (2) represents a substituent. Here, examples of the substituent include an alkyl group (preferably having 1 to 30 carbon atoms, more preferably 1 to 20 carbon atoms, and particularly preferably 1 to 10 carbon atoms, and for example, methyl, ethyl, iso-propyl, tert-butyl, n-octyl, n-decyl, n-hexadecyl, cyclopropyl, cyclopentyl, cyclohexyl and the like), an alkenyl group (preferably having 2 to 30 carbon atoms, more preferably 2 to 20 carbon atoms, and particularly preferably 2 to 10 carbon atoms, and for example, vinyl, allyl, 2-butenyl, 3-pentenyl and the like), an alkynyl group (preferably having 2 to 30 carbon atoms, more preferably 2 to 20 carbon atoms, and particularly preferably 2 to 10 carbon atoms, and for example, propargyl, 3-pentynyl and the like), an aryl group (preferably having 6 to 30 carbon atoms, more preferably 6 to 20 carbon atoms, and particularly preferably 6 to 12 carbon atoms, and for example, phenyl, p-methylphenyl, naphthyl, anthranyl and the like), and the like.

Furthermore, an amino group (preferably having 0 to 30 carbon atoms, more preferably 0 to 20 carbon atoms, and particularly preferably 0 to 10 carbon atoms, and for example, amino, methylamino, dimethylamino, diethylamino, dibenzylamino, diphenylamino, ditolylamino and the like), an alkoxy group (preferably having 1 to 30 carbon atoms, more preferably 1 to 20 carbon atoms, and particularly preferably 1 to 10 carbon atoms, and for example, methoxy, ethoxy, butoxy, 2-ethylhexyloxy and the like), an aryloxy group (preferably having 6 to 30 carbon atoms, more preferably 6 to 20 carbon atoms, and particularly preferably 6 to 12 carbon atoms, and for example, phenyloxy, 1-naphthyloxy, 2-naphthyloxy and the like), a heteroaryloxy group, (preferably having 1 to 30 carbons, more preferably 1 to 20 carbon atoms, and particularly preferably 1 to 12 carbon atoms, and for example, pyridyloxy, pyrazyloxy, pyrimidyloxy, quinolyloxy and the like), an acyl group (preferably having 1 to 30 carbon atoms, more preferably 1 to 20 carbon atoms, and particularly preferably 1 to 12 carbon atoms, and for example, acetyl, benzoyl, formyl, pivaloyl and the like), an alkoxycarbonyl group (preferably having 2 to 30 carbon atoms, more preferably 2 to 20 carbon atoms, and particularly preferably 2 to 12 carbon atoms, and for example, methoxycarbonyl, ethoxycarbonyl and the like), an aryloxycarbonyl group (preferably having 7 to 30 carbon atoms, more preferably 7 to 20 carbon atoms, and particularly preferably 7 to 12 carbon atoms, and for example, phenyloxycarbonyl and the like), may be mentioned.

There may also be mentioned an acyloxy group (preferably having 2 to 30 carbon atoms, more preferably 2 to 20 carbon atoms, and particularly preferably 2 to 10 carbon atoms, and for example, acetoxy, benzoyloxy and the like), an acylamino group (preferably having 2 to 30 carbon atoms, more preferably 2 to 20 carbon atoms, and particularly preferably 2 to 10 carbon atoms, and for example, acetylamino, benzoylamino and the like), an alkoxycarbonylamino group (preferably having 2 to 30 carbon atoms, more preferably 2 to 20 carbon atoms, and particularly preferably 2 to 12 carbon atoms, and for example, methoxycarbonylamino and the like), an aryloxycarbonylamino group (preferably having 7 to 30 carbon atoms, more preferably 7 to 20 carbon atoms, and particularly preferably 7 to 12 carbon atoms, and for example, phenyloxycarbonylamino and the like), and the like.

A sulfonylamino group (preferably having 1 to 30 carbon atoms, more preferably 1 to 20 carbon atoms, and particularly preferably 1 to 12 carbon atoms, and for example, methanesulfonylamino, benzenesulfonylamino and the like), a sulfamoyl group (preferably having 0 to 30 carbon atoms, more preferably 0 to 20 carbon atoms, and particularly preferably 0 to 12 carbon atoms, and for example, sulfamoyl, methylsulfamoyl, dimethylsulfamoyl, phenylsulfamoyl and the like), a carbamoyl group (preferably having 1 to 30 carbon atoms, more preferably 1 to 20 carbon atoms, and particularly preferably 1 to 12 carbon atoms, and for example, carbamoyl, methylcarbamoyl, diethylcarbamoyl, phenylcarbamoyl and the like), an alkylthio group (preferably having 1 to 30 carbon atoms, more preferably 1 to 20 carbon atoms, and particularly preferably 1 to 12 carbon atoms, and for example, methylthio, ethylthio and the like), an arylthio group (preferably having 6 to 30 carbon atoms, more preferably 6 to 20 carbon atoms, and particularly preferably 6 to 12 carbon atoms, and for example, phenylthio and the like), a heteroarylthio group (preferably having 1 to 30 carbon atoms, more preferably 1 to 20 carbon atoms, and particularly preferably 1 to 12 carbon atoms, and for example, pyridylthio, 2-benzimidazolylthio, 2-benzoxazolylthio, 2-benzothiazolylthio and the like), and the like may be mentioned.

A sulfonyl group (preferably having 1 to 30 carbon atoms, more preferably 1 to 20 carbon atoms, and particularly preferably 1 to 12 carbon atoms, and for example, mesyl, tosyl and the like), a sulfinyl group (preferably having 1 to 30 carbon atom, more preferably 1 to 20 carbon atoms, and particularly preferably 1 to 12 carbon atoms, and for example, methanesulfinyl, benzenesulfinyl and the like), a ureido group (preferably having 1 to 30 carbon atoms, more preferably 1 to 20 carbon atoms, and particularly preferably 1 to 12 carbon atoms, and for example, ureido, methylureido, phenylureido and the like), a phosphoric acid amide group (preferably having 1 to 30 carbon atoms, more preferably 1 to 20 carbon atoms, and particularly preferably 1 to 12 carbon atoms, and for example, diethylphosphoric acid amide, phenylphosphoric acid amide and the like), and the like may be mentioned.

A hydroxyl group, a mercapto group, a halogen atom (for example, a fluorine atom, a chlorine atom, a bromine atom or an iodine atom), a cyano group, a sulfo group, a carboxyl group, a nitro group, a hydroxamic acid group, a sulfino group, a hydrazino group, an imino group, a heterocyclic group (preferably having 1 to 30 carbon atoms, more preferably 1 to 12 carbon atoms, and having a nitrogen atom, an oxygen atom, a sulfur atom or the like for example as the heteroatom; specifically, for example, imidazolyl, pyridyl, quinolyl, furyl, thienyl, piperidyl, morpholino, benzoxazolyl, benzimidazolyl, benzothiazolyl, a carbazolyl group, an azepinyl group and the like), a silyl group (preferably having 3 to 40 carbon atoms, more preferably 3 to 30 carbon atoms, and particularly preferably 3 to 24 carbon atoms, and for example, trimethylsilyl, triphenylsilyl and the like), and the like may be mentioned.

When $R^1$ is present in plurality, each $R^1$ may be identical with or different from another $R^1$, and they may be joined to form a ring. Further, $R^1$ may be further substituted.

n1 represents an integer from 0 to 9. n1 is preferably an integer from 0 to 6, and more preferably 0 to 3.

Subsequently, the formula (3) will be described.

In the formula (3), $R^2$ represents a substituent. The substituent $R^2$ has the same meaning as the substituent $R^1$, including the preferred embodiments.

n2 represents an integer from 0 to 20. A preferred range of n2 is from 0 to 10, and more preferably from 0 to 5.

Examples of the compound of formula (1) or formula (3) will be shown below, but the invention is not intended to be limited to these.

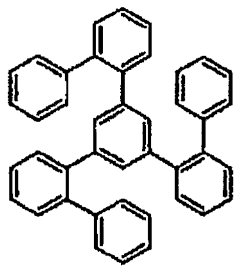

(1)

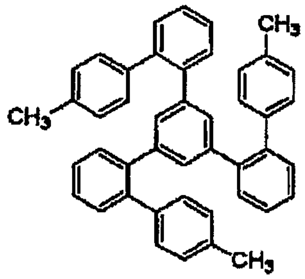

(2)

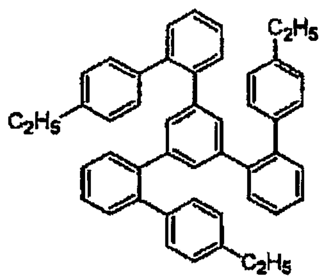

(3)

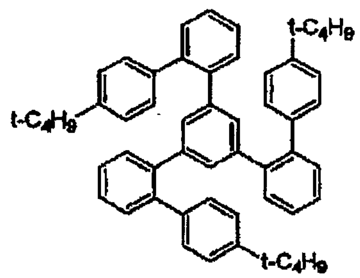

(4)

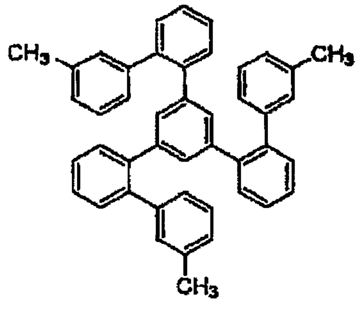

(5)

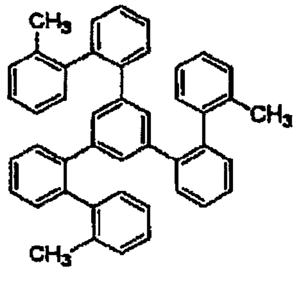

(6)

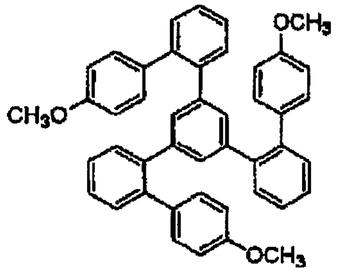
(7)

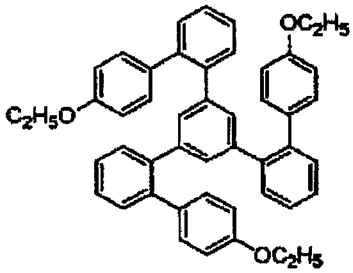
(8)

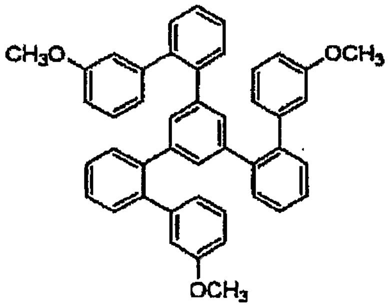
(9)

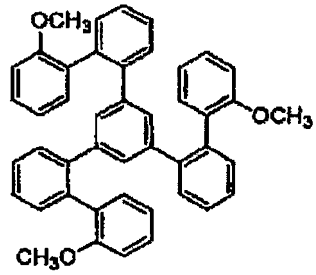
(10)

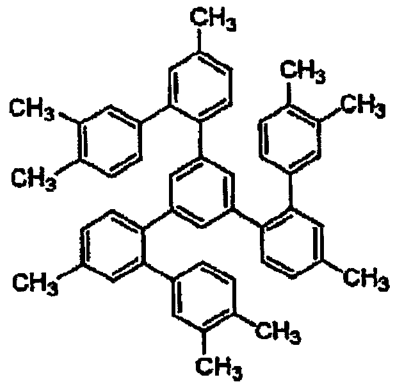
(11)

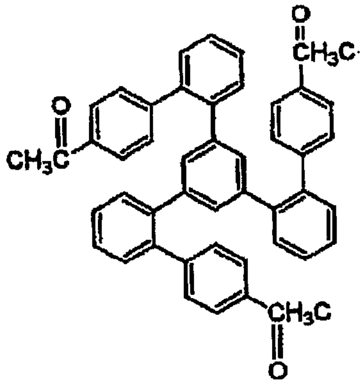
(12)

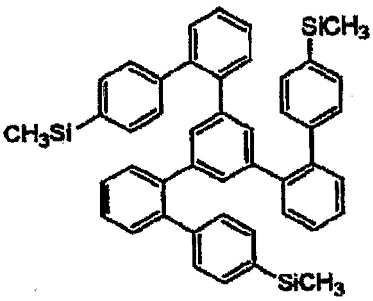
(13)

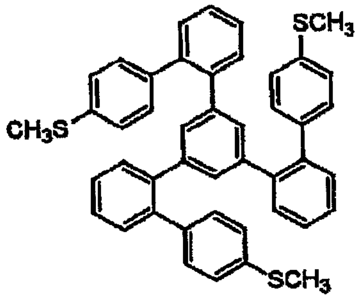
(14)

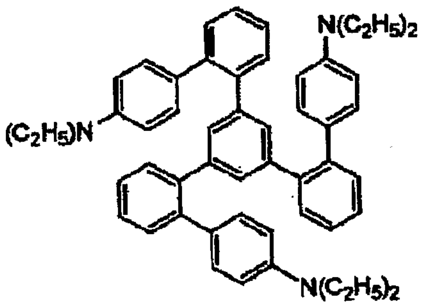

(15)

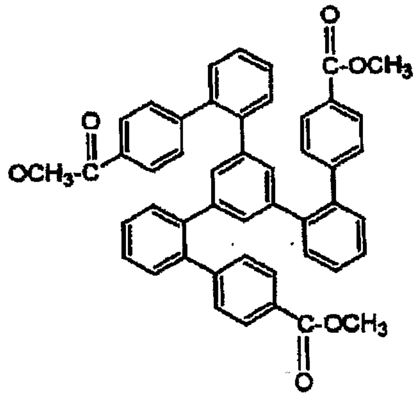

(16)

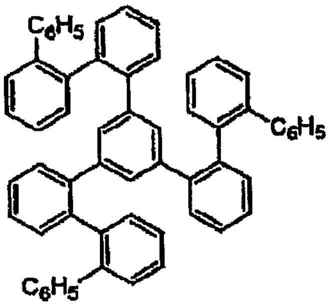

(17)

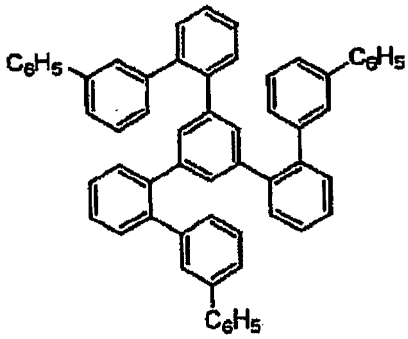

(18)

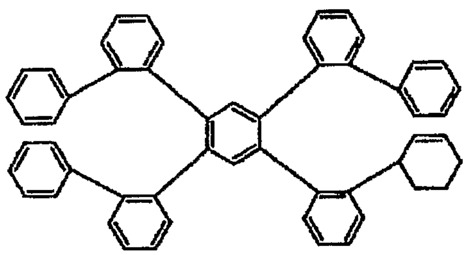

(19)

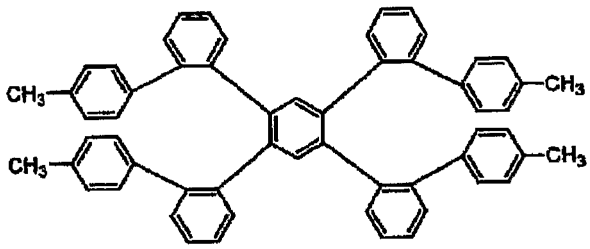

(20)

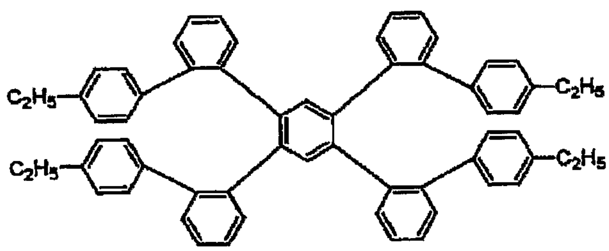

(21)

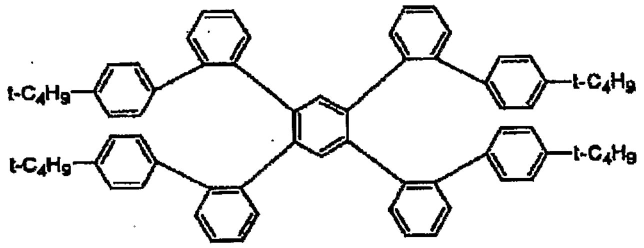

(22)

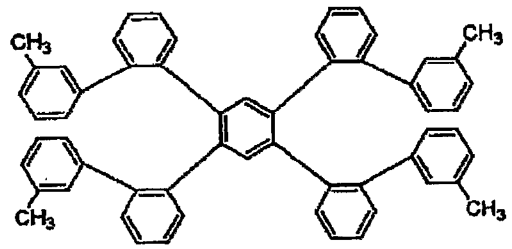

(23)

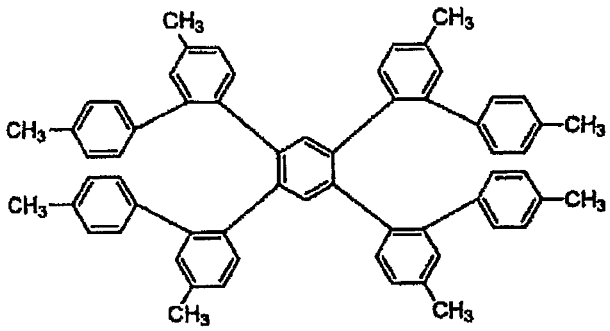

(24)

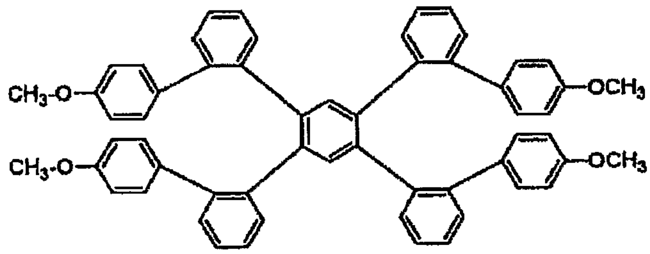

(25)

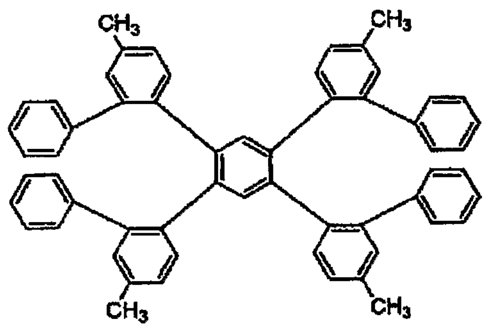

(26)

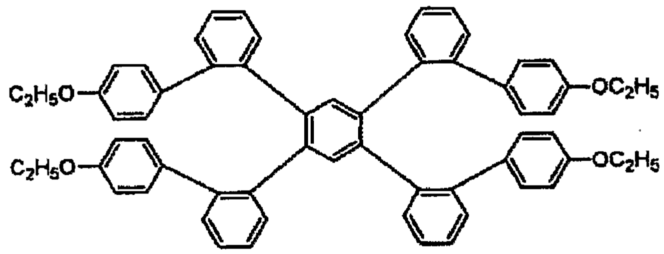

(27)

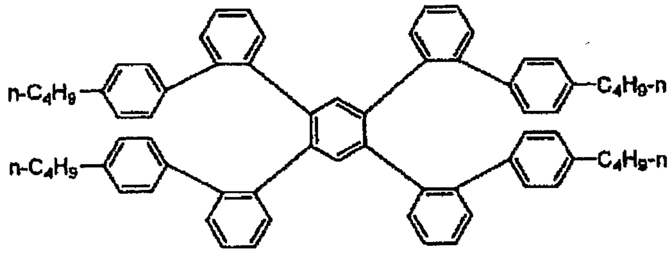

(28)

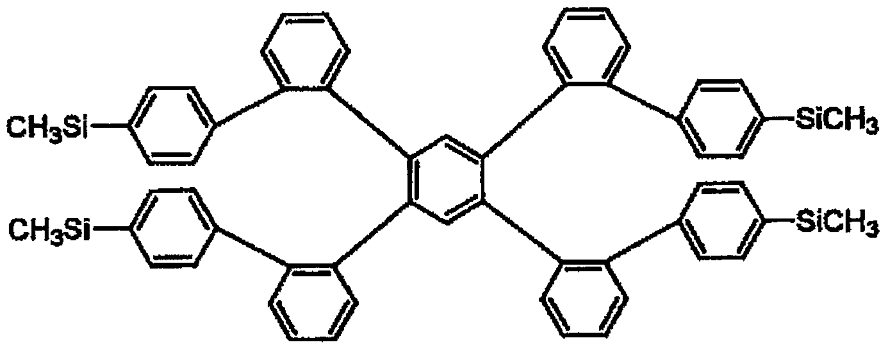

(29)

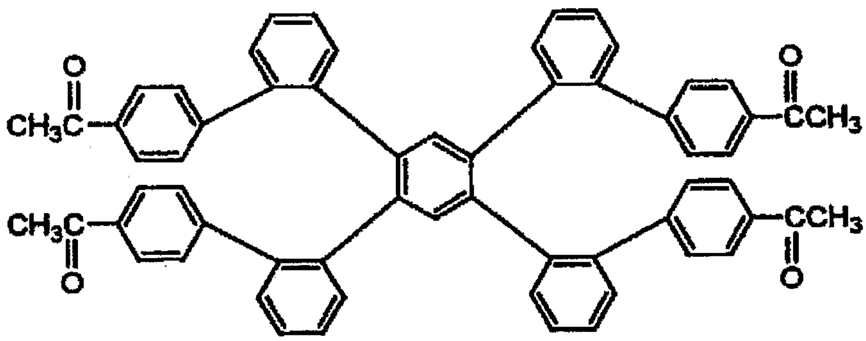

(30)

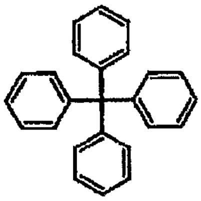

(31)

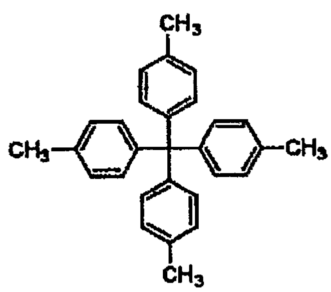

(32)

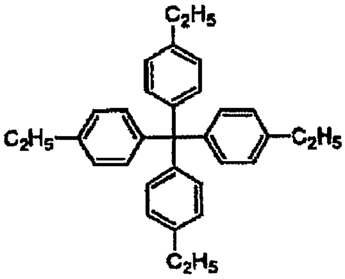 (33)

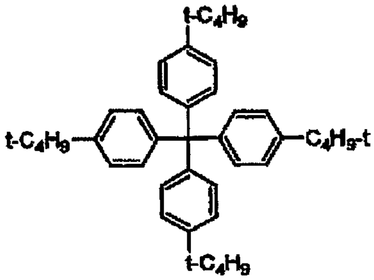 (34)

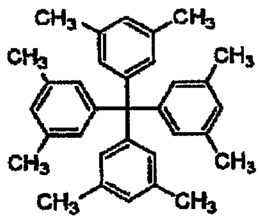 (35)

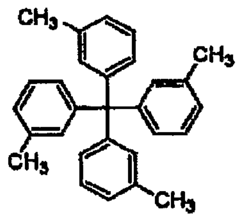 (36)

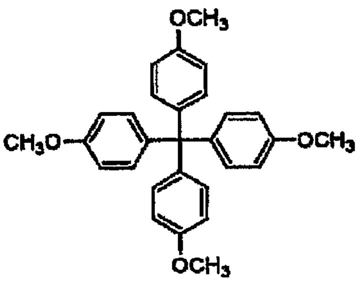 (37)

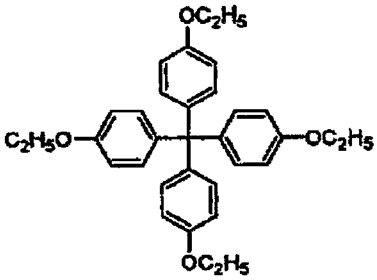 (38)

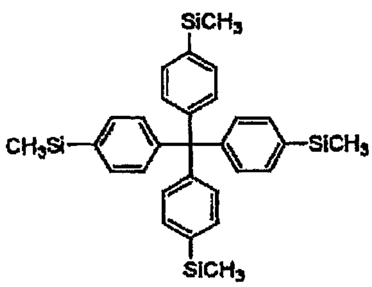 (39)

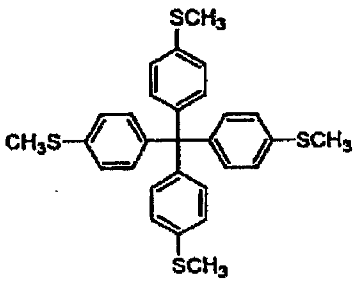 (40)

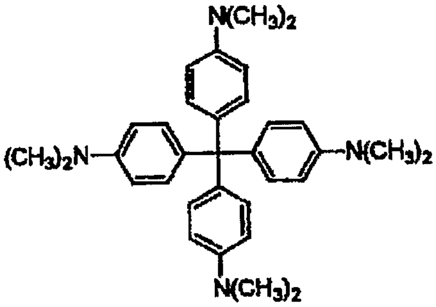 (41)

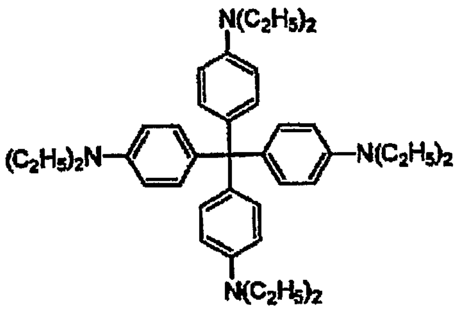 (42)

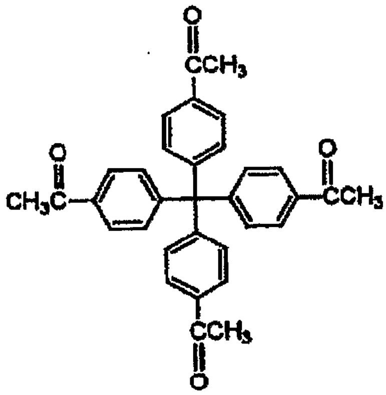

(43)

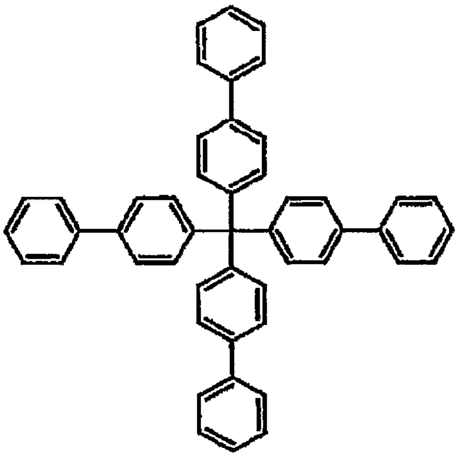

(44)

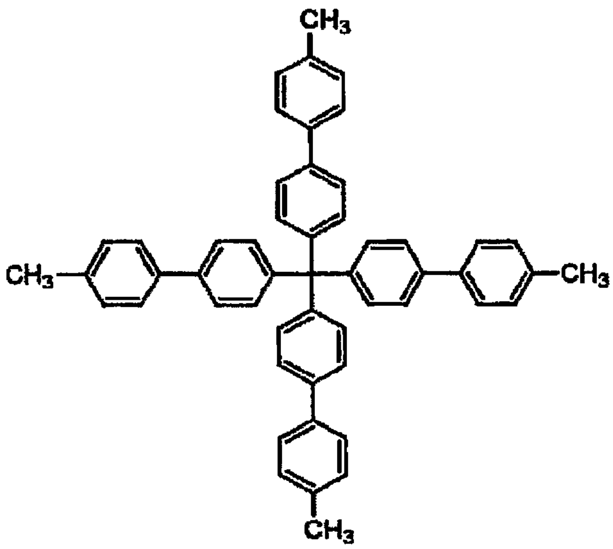

(45)

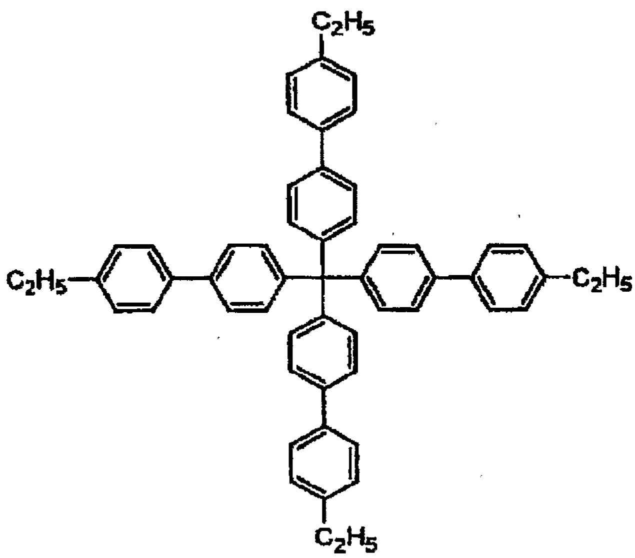

(46)

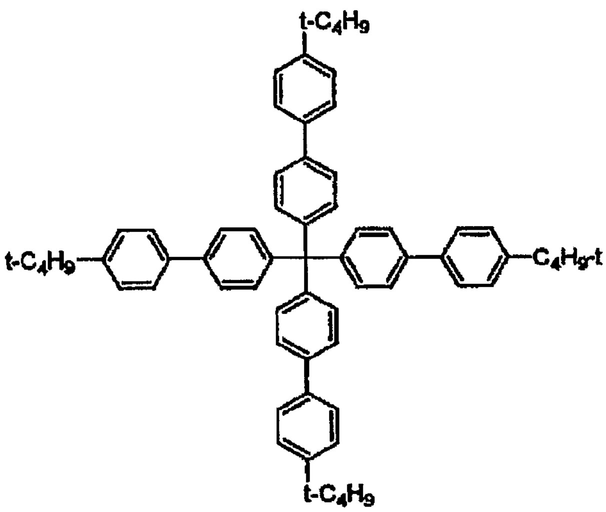

(47)

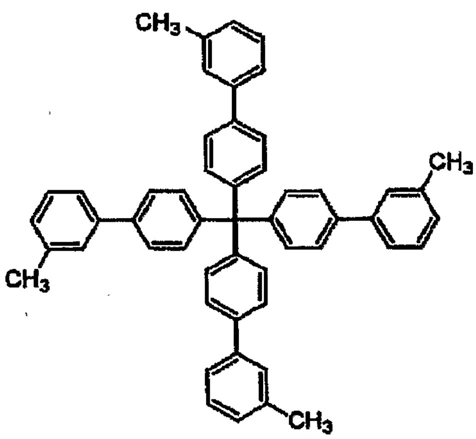

(48)

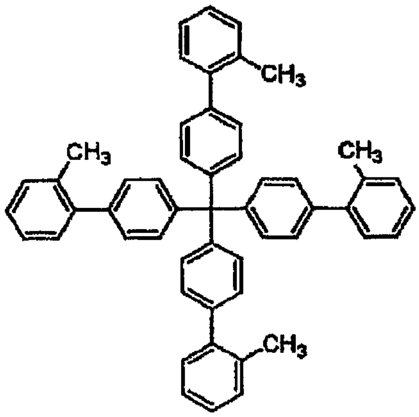

(49)

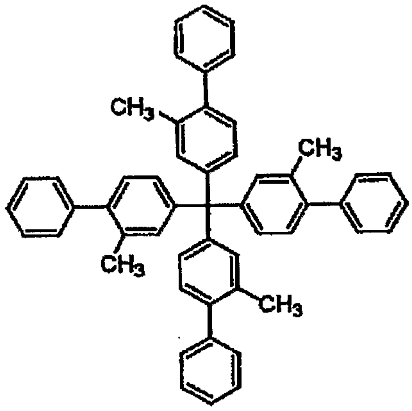

(50)

:

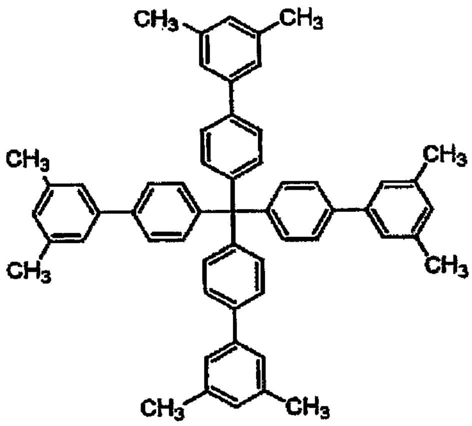

(51)

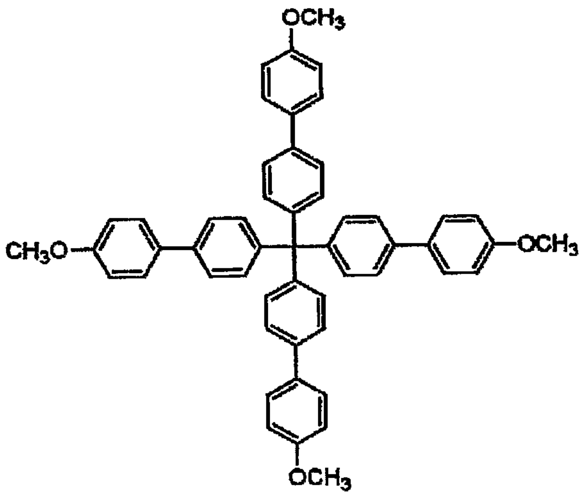

(52)

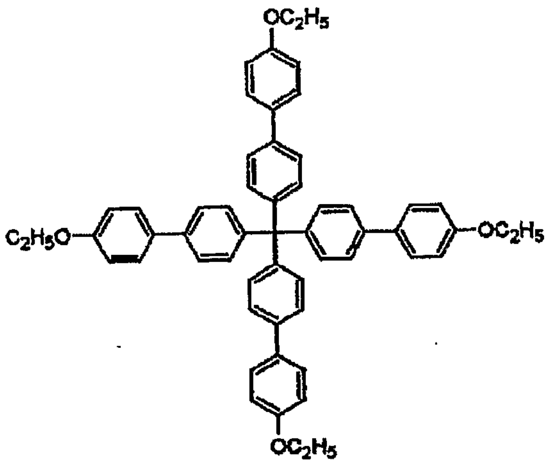

(53)

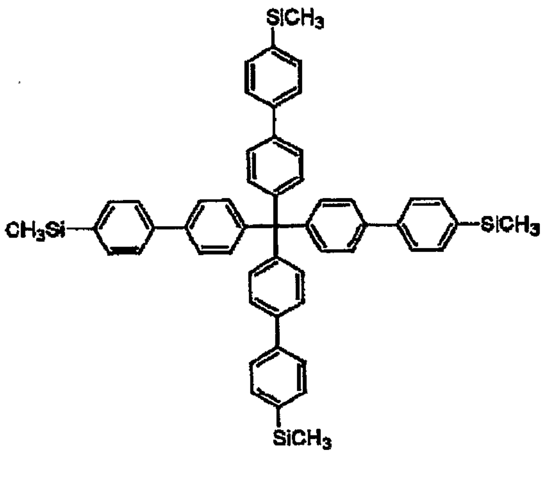

(54)

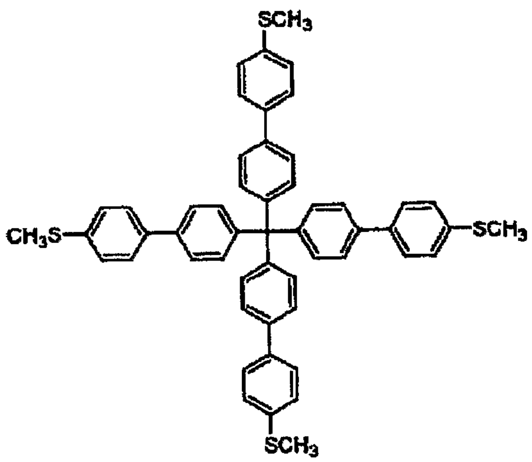

(55)

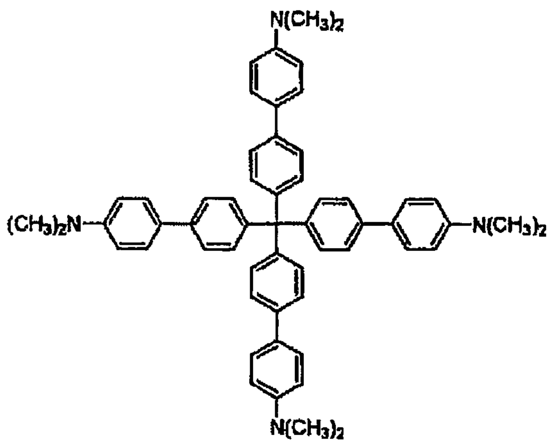

(56)

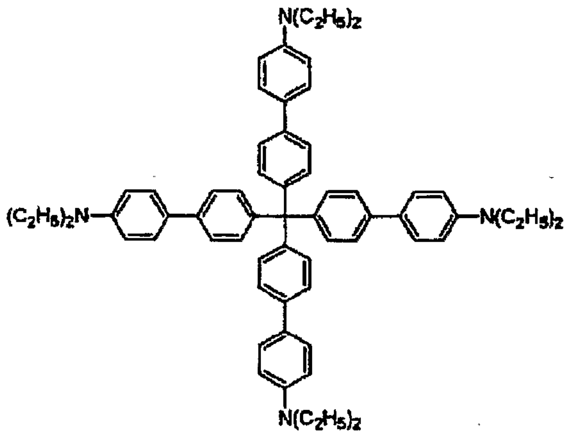

(57)

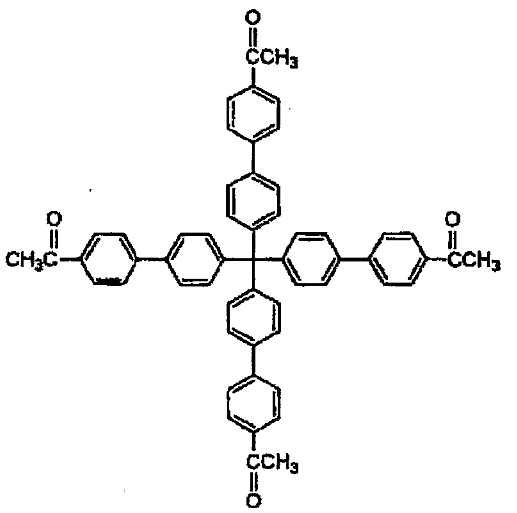

(58)

Another electrically inert organic material may be suitably selected from siloxane compounds. Examples of the compound will be shown below, but the invention is not intended to be limited to these.

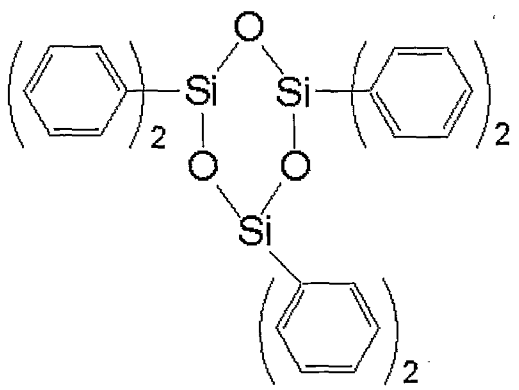

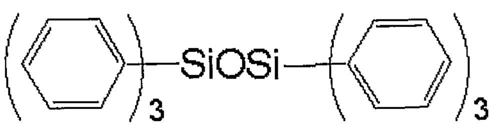

Meanwhile, the electrically inert inorganic material that may be included in the light emitting layer, is not particularly limited as long as it is an inorganic dielectric material having substantially no conductivity.

As for the inorganic material, for example, metal oxides, metal nitrides, metal carbides, metal halides, metal sulfates, metal nitrates, metal phosphates, metal sulfides, metal carbonates, metal borohalides, metal phosphohalides and the like may be used. Among them, from the viewpoint of the compatibility with light emitting materials or the adaptability for film formation, silicon oxide, silicon dioxide, silicon nitride, silicon oxynitride, silicon carbide, germanium oxide, germanium dioxide, tin oxide, tin dioxide, barium oxide, lithium fluoride, lithium chloride, cesium fluoride, cesium chloride and the like are preferred. More preferred are silicon nitride, silicon oxynitride, silicon oxide and silicon carbide. Zinc sulfide (ZnS) is also suitable.

Using (A) a light emitting material having electron transportability, (B) a host material having hole transportability and (C) an electrically inert material as described above, a light emitting layer is formed such that the concentration of the light emitting material having electron transportability gradually decreases from the cathode side toward the anode side. The method of forming such light emitting layer is not particularly limited if the light emitting layer may be formed such that the concentration of the light emitting material having electron transportability has a concentration gradient as described above, and any of dry film forming methods such as deposition methods or sputtering methods, transfer methods, printing methods and the like may be favorably used, with co-deposition being suitable. In the case of co-deposition, when the rate of deposition of each material is controlled, the light emitting layer may be formed to have a desired concentration distribution in the thickness direction thereof.

Although the thickness of the light emitting layer is not particularly limited, but usually, from the viewpoints of preventing the generation of pinholes in the light emitting layer, obtaining a sufficient luminescence intensity, and the like, the thickness is preferably 1 nm to 500 nm, more preferably 5 nm to 200 nm, and even more preferably 10 nm to 100 nm.

- Hole injection layer and hole transport layer -

The hole injection layer and the hole transport layer are layers having a function of receiving holes from the anode 14 or from the anode side, and transporting the holes to the light emitting layer side (cathode side). Specifically, the hole injection layer and the hole transport layer are preferably layers containing a pyrrole derivative, a carbazole derivative, an indole derivative, an imidazole derivative, a polyarylalkane derivative, a pyrazoline derivative, a pyrazolone derivative, a phenylenediamine derivative, an arylamine derivative, an amino-substituted chalcone derivative, a styrylanthracene derivative, a fluorenone derivative, a hydrazone derivative, a stilbene derivative, a silazane derivative, an aromatic tertiary amine compound, a styrylamine compound, an aromatic dimethylidine, a porphyrin compound, an organic silane derivative, various metal complexes having carbon, phenylazole or phenylazine as the ligand, represented by Ir complexes, or the like.

The hole injection layer and/or hole transport layer of the organic EL device of the invention may preferably contain an electron accepting dopant, from the viewpoint of voltage lowering and driving durability.

As long as the electron accepting dopant introduced into the hole injection layer or hole transport layer has a property of accepting an electron and oxidizing an organic compound, any of an inorganic compound and an organic compound may be used. Specific examples of the inorganic compound that may be suitably used include halides such as iron (II) chloride, aluminum chloride, gallium chloride, indium chloride and antimony pentachloride, and metal oxides such as vanadium pentoxide and molybdenum trioxide.

If the dopant is an organic compound, a compound having a nitro group, halogen, a cyano group or a trifluoromethyl group as the substituent, a quinone compound, an acid anhydride compound, fullerene or the like may be suitably used.

Specific examples thereof include hexacyanobutadiene, hexacyanobenzene, tetracyanoethylene, tetracyanoquinodimethane, tetrafluorotetracyanoquinodimethane, p-fluoranil, p-chloranil, p-bromanil, p-benzoquinone, 2,6-dichlorobenzoquinone, 2,5-dichlorobenzoquinone, tetramethylbenzoquinone, 1,2,4,5-tetracyanobenzene, o-dicyanobenzene, p-dicyanobenzene, 1,4-dicyanotetrafluorobenzene, 2,3-dichloro-5,6-dicyanobenzoquinone, p-dinitrobenzene, m-dinitrobenzene, o-dinitrobenzene, p-cyanonitrobenzene, m-cyanonitrobenzene, o-cyanonitrobenzene, 1,4-naphthoquinone, 2,3-dichloronaphthoquinone, 1-nitronaphthalene, 2-nitronaphthalene, 1,3-dinitronaphthalene, 1,5-dinitronaphthalene, 9-cyanoanthracene, 9-nitroanthracene, 9,10-anthraquinone, 1,3,6,8-tetranitrocarbazole, 2,4,7-trinitro-9-fluorenone, 2,3,5,6-tetracyanopyridine, maleic anhydride, phthalic anhydride, fullerene C60, fullerene C70 and the like. In addition to these, the compounds described in JP-A No. 6-212153, JP-A No. 11-111463, JP-ANo. 11-251067, JP-ANo. 2000-196140, JP-ANo. 2000-286054, JP-ANo. 2000-315580, JP-ANo. 2001-102175, JP-ANo. 2001-160493, JP-ANo. 2002-252085, JP-ANo. 2002-56985, JP-ANo. 2003-157981, JP-ANo. 2003-217862, JP-ANo. 2003-229278, JP-ANo. 2004-342614, JP-ANo. 2005-72012, JP-ANo. 2005-166637, JP-ANo. 2005-209643 and the like may be suitably used.

Among these, hexacyanobutadiene, hexacyanobenzene, tetracyanoethylene, tetracyanoquinodimethane, tetrafluorotetracyanoquinodimethane, p-fluoranil, p-chloranil, p-bromanil, p-benzoquinone, 2,6-dichlorobenzoquinone, 2,5-dichlorobenzoquinone, 1,2,4,5-tetracyanobenzene, 1,4-dicyanotetrafluorobenzene, 2,3-dichloro-5,6-dicyanobenzoquinone, p-dinitrobenzene, m-dinitrobenzene, o-dinitrobenzene, 1,4-naphthoquinone, 2,3-dichloronaphthoquinone, 1,3-dinitronaphthalene, 1,5-dinitronaphthalene, 9,10-anthraquinone, 1,3,6,8-tetranitrocarbazole, 2,4,7-trinitro-9-fluorenone, 2,3,5,6-tetracyanopyridine, and C60 are preferred, and hexacyanobutadiene, hexacyanobenzene, tetracyanoethylene, tetracyanoquinodimethane, tetrafluorotetracyanoquinodimethane, p-fluoranil, p-chloranil, p-bromanil, 2,6-dichlorobenzoquinone, 2,5-dichlorobenzoquinone, 2,3-dichloronaphthoquinone, 1,2,4,5-tetracyanobenzene, 2,3-dichloro-5,6-dicyanobenzoquinone, and 2,3,5,6-tetracyanopyridine are more preferred, with tetrafluorotetracyanoquinodimethane being particularly preferred.

These electron accepting dopants may be used individually, or may be used in combination of two or more species. The amount of use of the electron accepting dopant may vary depending on the type of material, but is preferably 0.01% by mass to 50% by mass, more preferably 0.05% by mass to 20% by mass, and particularly preferably 0.1% by mass to 10% by mass, based on the material of the hole transport layer. If the amount of use is less than 0.01% by mass based on the hole transporting material, the effect of the invention is insufficient, and thus it is not preferable. If the amount of use exceeds 50% by mass, the ability to transport holes is impaired, and thus it is not preferable.

It is preferable that the thicknesses of the hole injection layer and the hole transport layer are respectively 500 nm or less, from the viewpoint of lowering the driving voltage.

The thickness of the hole transport layer is preferably 1 nm to 500 nm, more preferably 5 nm to 200 nm, and even more preferably 5 nm to 100 nm. The thickness of the hole injection layer is preferably 0.1 nm to 500 nm, more preferably 0.5 nm to 400 nm, and even more preferably 1 nm to 300 nm.

Each of the hole injection layer and hole transport layer may have a single layer structure formed from one or two or more species of the materials mentioned above, or may also have a multilayer structure including plural layers having identical composition or different compositions.

- Electron injection layer and electron transport layer -

The electron injection layer and the electron transport layer are layers having a function of receiving electrons from the cathode 18 or from the cathode side, and transporting the electrons to the light emitting layer side (anode side). The electron injection layer and the electron transport layer are preferably layers containing, specifically, a triazole derivative, an oxazole derivative, an oxadiazole derivative, an imidazole derivative, a fluorenone derivative, an anthraquinodimethane derivative, an anthrone derivative, a diphenylquinone derivative, a thiopyrane dioxide derivative, a carbodiimide derivative, a fluorenylidenemethane derivative, a distyrylpyrazine derivative, an aromatic ring tetracarboxylic acid anhydride of naphthalene, perylene or the like, a phthalocyanine derivative, or various metal complexes represented by metal complexes of 8-quinole derivatives, metal phthalocyanine, and metal complexes having benzoxazole or benzothiazole as the ligand, an organic silane derivative, or the like.

The electron injection layer and/or electron transport layer of the organic EL device of the invention preferably contains an electron donating dopant from the viewpoint of lowering the voltage and improving the driving durability.

It is preferable that the electron donating dopant introduced into the electron injection layer or electron transport layer has a property of donating an electron and reducing an organic compound. An alkali metal such as Li, an alkaline earth metal such as Mg, a transition metal including a rare earth metal, a reducing organic compound or the like is suitably used.

As for the metal, particularly a metal having a work function of 4.2 eV or less may be suitably used, and specifically, Li, Na, K, Be, Mg, Ca, Sr, Ba, Y, Cs, La, Sm, Gd, Yb and the like may be mentioned.

As for the reducing organic compound, for example, a nitrogen-containing compound, a sulfur-containing compound, a phosphorus-containing compound and the like may be mentioned. In addition to these, the materials described in JP-ANo. 6-212153, JP-ANo. 2000-196140, JP-A No. 2003-68468, JP-A No. 2003-229278, JP-A No. 2004-342614 and the like may be used.

These electron donating dopants may be used individually, or may be used in combination of two or more species. The amount of use of the electron donating dopant may vary depending on the type of material, but the amount is preferably 0.1 % by mass to 99% by mass, more preferably 1.0% by mass to 80% by mass, and particularly preferably 2.0% by mass to 70% by mass, based on the material of the electron transport layer. If the amount of use is less than 0.1% by mass based on the material of the electron transport layer, the effect of the invention is insufficient, and thus it is not preferable. If the amount of use exceeds 99% by mass, the ability to transport electrons is impaired, and thus it is not preferable.

It is preferable that the thicknesses of the electron injection layer and the electron transport layer are respectively 500 nm or less, from the viewpoint of lowering the driving voltage.

The thickness of the electron transport layer is preferably 1 nm to 500 nm, more preferably 5 nm to 200 nm, and even more preferably 10 nm to 100 nm. The thickness of the electron injection layer is preferably 0.1 nm to 200 nm, more preferably 0.2 nm to 100 nm, and even more preferably 0.5 nm to 50 nm.

The electron injection layer and the electron transport layer may have a single layer formed from one or two or more species of the materials mentioned above, or may also have a multilayer structure including plural layers having identical composition or different compositions.

- Hole blocking layer -

The hole blocking layer is a layer having a function of preventing the holes transported to the light emitting layer from the anode side from passing through to the cathode side. The hole blocking layer may be provided to be adjacent to the cathode side of the light emitting layer.

Examples of the organic compound constituting the hole blocking layer include an aluminum complex such as BAlq, a triazole derivative, a phenanthroline derivative such as BCP, and the like.

The thickness of the hole blocking layer is preferably 1 nm to 500 nm, more preferably 3 nm to 200 nm, and even more preferably 5 nm to 50 nm.

The hole blocking layer may have a single layer structure formed from one or two or more species of the materials mentioned above, or may also have a multilayer structure including plural layers having identical composition or different compositions.

- Cathode -

The cathode 18 generally has a function as an electrode for injecting electrons to the organic layer 16, and is not particularly limited in the shape, structure, size or the like, and the constituent material may be appropriately selected from known electrode materials in accordance with the use, purpose or the like of the organic EL device 10. Examples of the material constituting the cathode 18 include metals, alloys, metal oxides, electrically conductive compounds,

mixtures thereof and the like. Specific examples thereof include an alkali metal (for example, Li, Na, K, Cs or the like), an alkaline earth metal (for example, Mg, Ca or the like), gold, silver, lead, aluminum, a sodium-potassium alloy, a lithium-aluminum alloy, a magnesium-silver alloy, indium, a rare earth metal such as ytterbium, and the like. These may be used individually and alone, but from the viewpoint of achieving a balance between stability and electron injectability, two or more species may be suitably used in combination.

Among these, the material constituting the cathode 18 is preferably an alkali metal or an alkaline earth metal from the viewpoint of electron injectability, or is preferably a material mainly containing aluminum from the viewpoint of excellent storage stability. The material mainly containing aluminum refers to aluminum only, or an alloy of aluminum with 0.01 to 10% by mass of an alkali metal or alkaline earth metal, or a mixture thereof (for example, a lithium-aluminum alloy, a magnesium-aluminum alloy or the like).

In addition, the materials for the cathode 18 are described in detail in, for example, JP-A No. 2-15595 and JP-A No. 51-121172, and the materials described in these publications may be applied to the invention as well.

The method for forming the cathode 18 is not particularly limited, and the cathode may be formed according to a known method. The cathode may be formed according to a method selected from, for example, wet methods such as a printing method or a coating method, physical methods such as vacuum deposition, sputtering or ion plating, chemical methods such as CVD or plasma CVD, and the like, while taking into consideration of the adaptability to the material constituting the cathode 18. For example, in the case of selecting a metal or the like as the material for the cathode 18, one or two or more species may be used simultaneously or sequentially to form the cathode 18 by a sputtering method or the like.

The thickness of the cathode 18 may be appropriately selected according to the material constituting the cathode 18 or the direction of light extraction, and is typically about 1 nm to 5 $\mu$m.

Patterning at the time of forming the cathode 18 may be carried out by chemical etching based on photolithography or the like, or may also be carried out by physical etching by means of laser or the like. Furthermore, patterning may also be carried out by vacuum deposition or sputtering with a mask superimposed thereon, and it is also acceptable to carry out a lift-off method or a printing method.

The position of formation of the cathode 18 is not particularly limited, and the cathode may be formed over the whole of the organic layer 16, or may be formed on a part thereof.

A dielectric layer formed from the fluoride, oxide or the like of an alkali metal or an alkaline earth metal may be formed between the cathode 18 and the organic EL layer 16, to a thickness of 0.1 to 5 nm. This dielectric layer may be interpreted as a kind of electron injection layer. The dielectric layer may be formed by, for example, vacuum deposition, sputtering, ion plating or the like.

As a lower electrode 14, an organic layer 16 and an upper electrode 18 are sequentially formed in this order on a supporting substrate 12, an organic EL device 10 having an organic layer 16 including at least a light emitting layer sandwiched between a pair of electrodes 14 and 18 facing each other as shown in Fig. 1, is formed. Thereby, the light emitting layer sandwiched between the electrodes 14 and 18 on the supporting substrate 12, emits light. For example, when light emitting layers corresponding to various colors are formed such that RGB is repeatedly disposed in parallel on the substrate 12, the organic EL device having the light emitting layers sandwiched between the two electrodes 14 and 18, constitutes a pixel.

- Sealing and the like -

After forming a cathode 18 on the organic layer 16, it is preferable to seal the organic device by coating it with a sealing member (protective layer), in order to suppress deterioration of the organic EL device caused by moisture or oxygen. As for the sealing member, glass, metals, plastics and the like may be used.

Furthermore, an external line such as a control wiring or a signal line is connected to each of the electrodes 14 and 18. Thereby, a display apparatus based on the organic EL device may be produced.

The organic EL device produced by the method as described above has a luminescence distribution in the light emitting layer approaching the luminescence in the entirety, and thus may have improved luminescence efficiency and durability. Particularly, in the case of blue phosphorescent device, the luminescence efficiency and durability may be improved, and also a decrease in the luminescence efficiency in high current regions may be very effectively prevented.

EXAMPLES

Hereinafter, Examples and Comparative Examples of the present invention will be described, but the invention is not intended to be limited to the following Examples.

Additionally, in the following Examples and Comparative Examples, "x% $\rightarrow$ y%" implies that when the concentration at the anode side (% by mass) is designated as x%, and the concentration at the cathode side (% by mass) is designated as y%, the concentration changes continuously from the anode side toward the cathode side.

<Example 1>

An ITO film (thickness 100 nm) is formed as an anode on a supporting substrate (material: glass), and then using a vacuum deposition apparatus ($1\times10^{-6}$ torr), co-deposition was performed thereon using 2-TNATA (4,4',4"-tris(2-naphtylphenylamino)triphenylamine), and F4-TCNQ (tetrafluorotetracyanoquinodimethane) in an amount of 1.0% by mass based on 2-TNATA, to form a hole injection layer having a thickness of 160 nm. Subsequently, a film of NPD (N,N'-dinaphthyl-N,N'-diphenyl-[1,1'-biphenyl]-4,4'-diamine) was formed as a hole transport layer having a thickness of 10 nm. The structural formulas of 2-TNATA, F4-TCNQ and NPD are as follows.

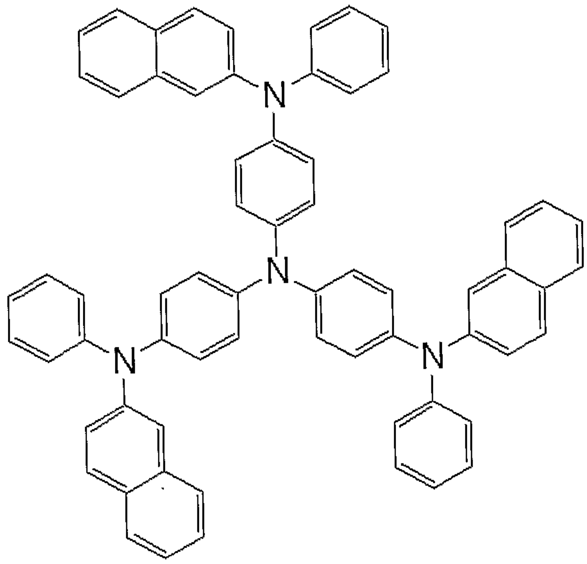

2-TNATA

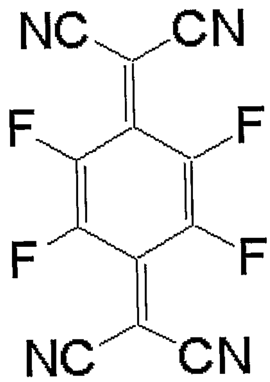

F4-TCNQ

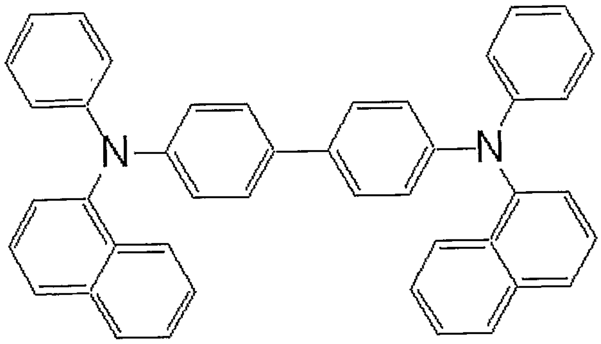

NPD

After forming the hole transport layer, a light emitting layer was laminated thereon. The light emitting layer was formed as a mixed layer (thickness 60 nm) by co-deposition using mCP (N,N'-dicarbazolyl-3,5-benzene) as a host material having hole transportability, Pt-1 as a light emitting material (blue light emitting material) having electron transportability, and compound A as an electrically inert material (binder). The structural formulas of mCP, Pt-1 and compound A are as follows.

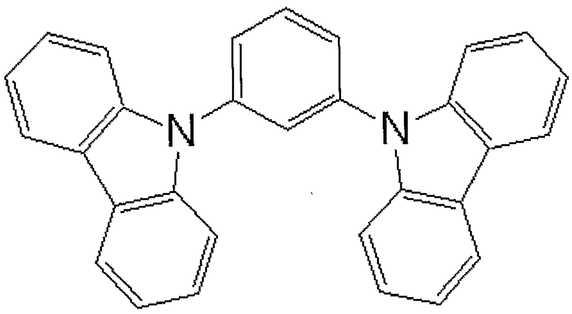

mCP

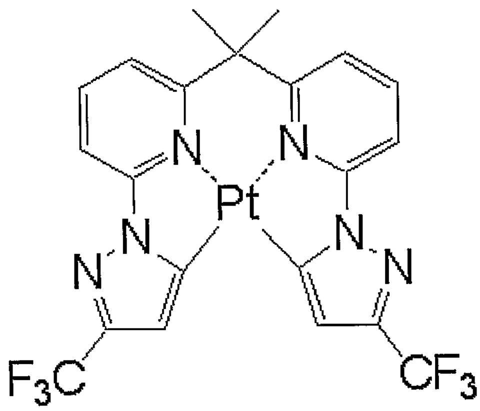

Pt-1

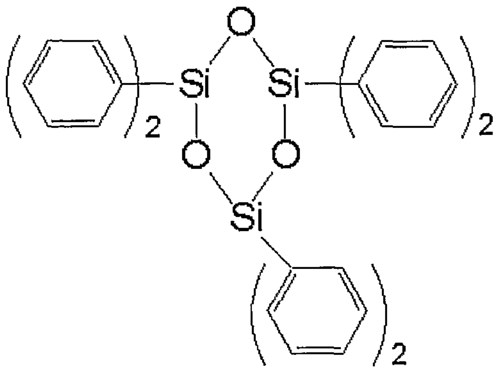

Compound A

At the time of forming the light emitting layer, the light emitting layer was formed such that the various materials have concentration distributions as shown in Fig. 4A, by varying the deposition rate of the respective constituent materials. Specifically, the concentration of Pt-1 was continuously increased from 0% at the interface at the anode side to 26% at the interface at the cathode side, while the concentration of mCP was continuously decreased from 26% at the interface at the anode side to 0% at the interface at the cathode side. The concentration of the compound A (organic binder) was made constant at 74% from the interface at the anode side to the interface at the cathode side. The respective concentrations of the materials in the region near the interface at the anode side were 1.3% for Pt-1, 24.7% for mCP, and 74% for the compound A, while the respective concentrations in the region near the interface at the cathode side were 24.7% for Pt-1, 1.3% for mCP, and 74% for the compound A.

After forming the light emitting layer, a film of BAlq was formed as an electron transport layer to a thickness of 40 nm. The structural formula of BAlq is as follows.

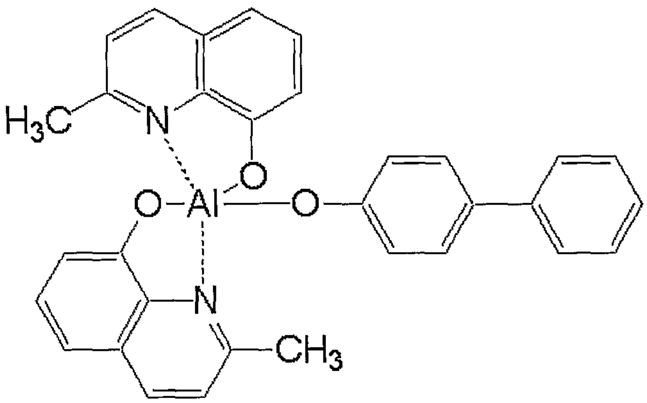

BAlq

After forming the electron transport layer, a LiF film was formed thereon to a thickness of 1 nm, and a film of Al (thickness 100 nm) was further formed as a cathode thereon.

As such, an organic EL device having an organic layer including a light emitting layer sandwiched between an ITO anode and an Al cathode was produced. The layer configuration, thickness of each layer, and the like are as follows.

ITO (100 nm)/2-TNATA+ 1.0% F4-TCNQ (160 nm)/NPD (10 nm)/26% → 0% mCP + 74% organic binder + 0% → 26% Pt-1 (60 nm)/BAlq (40 nm)/LiF (1 nm)/Al (100 nm)

The external quantum efficiency and the luminance half-life of the obtained organic EL device (luminescent device) were measured by the following methods.

<Measurement of external quantum efficiency>

A direct current voltage was applied to the produced luminescent device using a source measure unit Model

2400 manufactured by Keithley Instruments, Inc., to allow the luminescent device to emit blue light. The luminescence spectrum and the quantity of light were measured using a luminance meter SR-3 manufactured by Topcon Technohouse Corp., and the external quantum efficiency was calculated from the luminescence spectrum, quantity of light and the current applied during the measurement.

<Measurement of luminance half-life>

The luminescent device was subjected to continuous light emission by constant current driving at an initial luminance of 360 cd/$m^2$, and the time taken for the luminance to reach 180 cd/$m^2$ (luminance half-life) was measured.

As a result of the above measurements, the external quantum efficiency at 360 cd/$m^2$ was 12.0%, and the luminance half-life was 1700 hours.

<Example 2>

A blue emitting organic EL device having the same layer configuration as in Example 1 was produced in the same manner as in Example 1, except that silicon oxide <SiO> (inorganic binder) was used instead of the compound A (organic binder) used in the case of forming the light emitting layer in Example 1. The respective concentration distributions of the materials in the light emitting layer are presented in Fig. 4B. The layer configuration, thickness of each of the layers, and the like of the luminescent device are as follows.

ITO (100 nm)/2-TNATA + 1.0% F4-TCNQ (160 nm)/NPD (10 mn)/26% → 0% mCP + 74% inorganic binder + 0% → 26% Pt-1 (60 nm)/BAlq (40 nm)/LiF (1 nm)/Al (100 nm)

The external quantum efficiency and the luminance half-life of the obtained organic EL device were measured under the same conditions as in Example 1 (hereinafter, the same), and as a result, the external quantum efficiency at 360 cd/$m^2$ was 12.5%, while the luminance half-life was 1800 hours.

<Example 3>

An organic EL device having the same layer configuration and thicknesses as in the organic EL device of Example 1, except for the light emitting layer, was produced. The light emitting layer was formed using the same materials as those used in Example 1, such that the respective materials have concentration distributions as shown in Fig. 4C. The layer configuration, thickness of each of the layers, and the like of the luminescent device are as follows.

ITO (100 nm)/2-TNATA + 1.0% F4-TCNQ (160 nm)/NPD (10 nm)/100% → 0% mCP

+ 0% → 74%

~~+ 74%~~ organic binder + 0% → 26% Pt-1 (60 nm)/BAlq (40 nm)/LiF (1 nm)/Al (100 nm)

The external quantum efficiency and the luminance half-life of the obtained organic EL device were measured, and as a result, the external quantum efficiency at 360 cd/$m^2$ was 13.5%, while the luminance half-life was 2000 hours.

It is conceived that when the concentration of the binder in the light emitting layer was gradually decreased from the cathode side toward the anode side, the luminescence efficiency and the luminance half-life were further improved.

Furthermore, the external quantum efficiency was measured at a high luminance of 10000 cd/$m^2$, and as a result, the value was 13.1%. This implies that 97% of the external quantum efficiency at 360 cm/$m^2$ was maintained, and thus the decrease in efficiency under a high luminance condition was very small.

<Comparative Example 1>

An organic EL device having the same layer configuration and thicknesses as in the organic EL device of Example 1, except for the light emitting layer, was produced. The light emitting layer was formed using mCP and Pt-1, such that the respective materials have concentration distributions as shown in Fig. 5A. The layer configuration, thickness of each of the layers, and the like of the luminescent device are as follows.

ITO (100 nm)/2-TNATA + 1.0% F4-TCNQ (160 nm)/NPD (10 nm)/100% → 74% mCP + 0% → 26% Pt-1 (60 nm)/BAlq (40 nm)/LiF (1 nm)/Al (100 nm)

The external quantum efficiency and the luminance half-life of the obtained organic EL device were measured, and as a result, the external quantum efficiency at 360 cd/$m^2$ was 9.1%, and the luminance half-life was 1200 hours.

Furthermore, the external quantum efficiency at a high luminance of 10000 cd/$m^2$ was measured to be 8.5%. This implies that 93% of the external quantum efficiency at 360 cd/$m^2$ was maintained, and thus the decrease in efficiency was larger compared to the case of Example 3.

<Comparative Example 2>

An organic EL device having the same layer configuration and thicknesses as in the organic EL device of Example 1, except for the light emitting layer, was produced. The light emitting layer was formed using mCP and Pt-1, as well as CBP (4,4'-dicarbazole-biphenyl) having a structural formula as shown below as a host material having hole transportability, such that the respective materials have concentration distributions as shown in Fig. 5B.

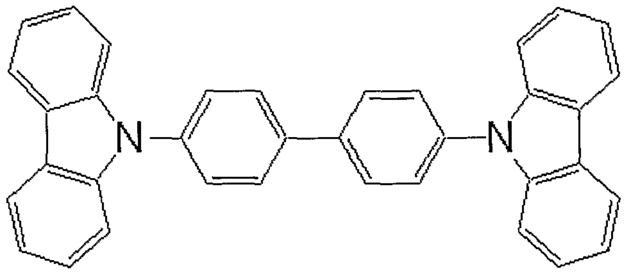

CBP

The layer configuration, thickness of each of the layers, and the like of the luminescent device are as follows.

ITO (100 nm)/2-TNATA + 1.0% F4-TCNQ (160 nm)/NPD (10 nm)/26% $\rightarrow$ 0% mCP + 74% CBP + 0% $\rightarrow$ 26% Pt-1 (60 nm)/BAlq (40 nm)/LiF (1 nm)/Al (100 nm)

The external quantum efficiency and the luminance half-life of the obtained organic EL device were measured, and as a result, the external quantum efficiency at 360 cd/$m^2$ was 8.0%, and the luminance half-life was 1100 hours.

<Comparative Example 3>

An organic EL device having the same layer configuration and thicknesses as in the organic EL device of Example 1, except for the light emitting layer, was produced. The light emitting layer was formed using the same materials as those used in Example 1, but the respective concentrations of the materials were maintained constant in the thickness direction of the light emitting layer, as shown in Fig. 5C. The layer configuration, thickness of each of the layers, and the like of the luminescent device are as follows.

ITO (100 nm)/2-TNATA + 1.0% F4-TCNQ (160 nm)/NPD (10 nm)/13% mCP + 74% organic binder + 13% Pt-1 (60 nm)/BAlq (40 nm)/LiF (1 nm)/Al (100 nm)

The external quantum efficiency and the luminance half-life of the obtained organic EL device were measured, and as a result, the external quantum efficiency at 360 cd/$m^2$ was 10.0%, and the luminance half-life was 1000 hours.

<Example 4>

An organic EL device was produced in the same manner as in Example 3, except that the light emitting material having electron transportability in the light emitting layer of Example 3 was changed from Pt-1 to Pt-2 (green light emitting layer), and the electrically inert material (binder) was changed from compound A to compound B. The structural formulas of Pt-2 and the compound B are as follows.

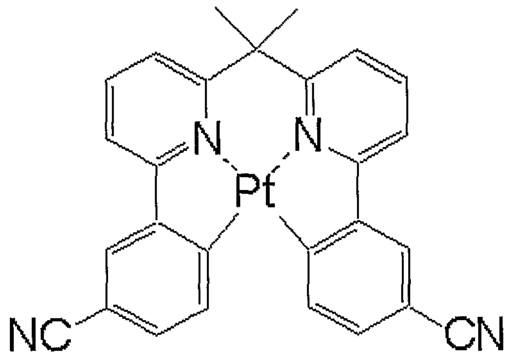

Pt-2

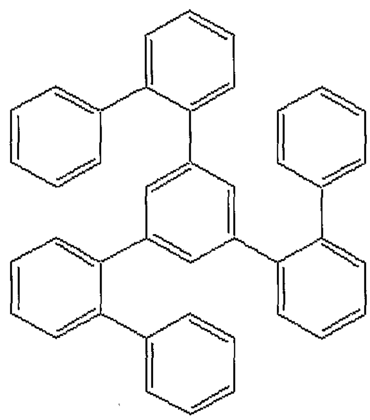

Compound B

When a voltage was applied to the obtained organic EL device, green light emission was observed. Thus, the external quantum efficiency was measured, and as a result, the external quantum efficiency at 500 cd/$m^2$ was 16.5%.
The external quantum efficiency at a high luminance of 10000 cd/$m^2$ was measured to be 15.8%. This implies that 96% of the external quantum efficiency at 500 cd/$m^2$ was maintained, and thus the decrease in efficiency under a high luminance condition was small.
The invention has been illustrated as shown above, but the invention is not intended to be limited to the above exemplary embodiments and Examples.
For example, the respective concentration distributions of the constituent materials in the light emitting layer of the organic EL device according to the invention are not limited to those shown in Fig. 2 to Fig. 4, but it is acceptable as long as, for example, as shown in Fig. 7, the concentration of the light emitting material having electron transportability gradually decreases from the cathode side toward the anode side.
Furthermore, in the case of producing a luminescent apparatus or a display apparatus provided with the organic EL device according to the invention, the driving mode is not limited, and either of the passive matrix mode and the active matrix mode may be employed. The color of emitted light is also not limited, and the invention may be applied to any of monochromatic displays, area color displays and full color displays.

**Claims**

**1.** An organic electroluminescent device comprising:

an anode,
a cathode disposed facing the anode, and

an organic layer that is sandwiched between the anode and the cathode and that includes at least a light emitting layer,
wherein the light emitting layer comprises a light emitting material having electron transportability, a host material having hole transportability, and an electrically inert material, and the concentration of the light emitting material having electron transportability gradually decreases from a cathode side toward an anode side across the entirety of the thickness of the light emitting layer.

**2.** The organic electroluminescent device according to claim 1, wherein the concentration of the electrically inert material in the light emitting layer gradually decreases from the cathode side toward the anode side.

**3.** The organic electroluminescent device according to claim 2, wherein the concentration in mass % of the light emitting material having electron transportability in a region near an interface at the anode side of the light emitting layer is from 0 % to 50 % relative to the concentration in mass % of the light emitting material having electron transportability in a region near an interface at the cathode side of the light emitting layer.

**4.** The organic electroluminescent device according to claim 3, wherein the concentration of the light emitting material having electron transportability in the light emitting layer is from 0 % by mass to 10 % by mass in the region near the interface at the anode side.

**5.** The organic electroluminescent device according to claim 1, wherein the electrically inert material is an organic material having an energy difference Eg between the highest occupied molecular orbital and the lowest unoccupied molecular orbital of 4.0 eV or greater.

**6.** The organic electroluminescent device according to claim 5, wherein the organic material is a compound represented by the following formula (1):

Formula (1) $L\text{-}(Ar)_m$

wherein Ar represents a group represented by the following formula (2); L represents a trivalent or higher-valent benzene skeleton; and m represents an integer of 3 or more:

Formula (2)

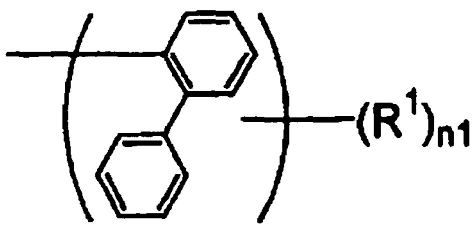

wherein $R^1$ represents a substituent, and when $R^1$ is present in plurality, each $R^1$ may be identical with or different from another $R^1$; and n1 represents an integer from 0 to 9.

**7.** The organic electroluminescent device according to claim 5, wherein the organic material is a siloxane compound.

**8.** The organic electroluminescent device according to claim 1, wherein the electrically inert material is an inorganic dielectric material.

**9.** The organic electroluminescent device according to claim 8, wherein the inorganic dielectric material is at least one selected from the group consisting of silicon nitride, silicon oxynitride, silicon oxide and silicon carbide.

**10.** The organic electroluminescent device according to claim 1, wherein the light emitting material is a phosphorescent light emitting material.

**11.** The organic electroluminescent device according to claim 1, wherein the peak wavelength of the luminescence

spectrum lies between 430 nm and 480 nm.

**Patentansprüche**

1. Eine organische elektrolumineszierende Vorrichtung, umfassend:

   Eine Anode,
   eine Kathode angeordnet in Richtung der Anode, und
   eine organische Schicht, die zwischen der Anode und der Kathode angeordnet ist und welche mindestens eine lichtemittierende Schicht enthält,
   wobei die lichtemittierende Schicht ein lichtemittierendes Material mit Elektronentransporteigenschaft, ein Wirtmaterial mit Lochtransporteigenschaft und ein elektrisch inertes Material umfasst, und die Konzentration des lichtemittierenden Materials mit Elektronentransporteigenschaft sich von der Kathodenseite zur Anodenseite über die Gesamtdicke der lichtemittierenden Schicht graduell verringert.

2. Organische elektrolumineszierende Vorrichtung nach Anspruch 1, wobei die Konzentration des elektrisch inerten Materials in der lichtemittierenden Schicht sich von der Kathodenseite zur Anodenseite graduell verringert.

3. Organische elektrolumineszierende Vorrichtung nach Anspruch 2, wobei die Konzentration in Massen-% des lichtemittierenden Materials mit Elektronentransporteigenschaft in einem Bereich nahe an der Grenzfläche bei der Anodenseite der lichtemittierenden Schicht von 0 % bis 50 % relativ zur Konzentration in Massen-% des lichtemittierenden Materials mit Elektronentransporteigenschaft in einem Bereich nahe an der Grenzfläche bei der Kathodenseite der lichtemittierenden Schicht liegt.

4. Organische elektrolumineszierende Vorrichtung nach Anspruch 3, wobei die Konzentration des lichtemittierenden Materials mit Elektronentransporteigenschaft in der lichtemittierenden Schicht von 0 Massen-% bis 10 Massen-% in dem Bereich nahe der Grenzfläche bei der Anodenseite beträgt.

5. Organische elektrolumineszierende Vorrichtung nach Anspruch 1, wobei das elektrisch inerte Material ein organisches Material mit einer Energiedifferenz Eg zwischen dem höchsten besetzten Molekülorbital und dem niedrigsten unbesetzten Molekülorbital von 4.0 Elektronenvolt oder größer.

6. Organische elektrolumineszierende Vorrichtung nach Anspruch 5, wobei das organische Material eine Verbindung ist, die durch die folgende Formel (1) wiedergegeben wird:

   $$L\text{-}(Ar)_m$$

   wobei Ar für eine Gruppe steht die durch die folgende Formel (2) wiedergegeben wird; L steht für ein trivalentes oder höhervalentes Benzolgerüst; und m steht für eine ganze Zahl von 3 oder mehr:

   Formel (2)

   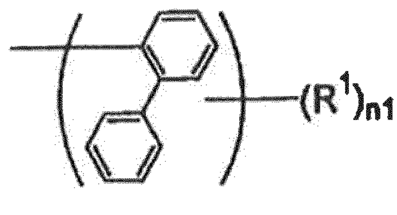

   wobei $R^1$ für einen Substituenten steht, und wenn $R^1$ in Mehrzahl vorliegt kann jedes $R^1$ identisch oder unterschiedlich zu den anderen $R^1$ sein; und n1 steht für eine ganze Zahl von 0 bis 9.

7. Organische elektrolumineszierende Vorrichtung nach Anspruch 5, wobei das organische Material eine Siloxanverbindung ist.

8. Organische elektrolumineszierende Vorrichtung nach Anspruch 1, wobei das elektrisch inerte Material ein anorganisches dielektrisches Material ist.

**9.** Organische elektrolumineszierende Vorrichtung nach Anspruch 8, wobei das anorganische dielektrische Material mindestens eines ausgewählt aus der Gruppe bestehend aus Siliziumnitrid, Siliziumoxynitrid, Siliziumoxid und Siliziumcarbid ist.

**10.** Organische elektrolumineszierende Vorrichtung nach Anspruch 1, wobei das lichtemittierende Material ein phorsphoreszentes lichtemittierendes Material ist.

**11.** Organische elektrolumineszierende Vorrichtung nach Anspruch 1, wobei die Peak-Wellenlänge des Lumineszenzspektrums zwischen 430 nm und 480 nm liegt.

**Revendications**

**1.** Un dispositif électroluminescent organique comportant :

une anode,
une cathode disposée face à l'anode, et
une couche organique qui est prise en sandwich entre l'anode et la cathode et qui comprend au moins une couche émettant de la lumière,
dans lequel la couche émettant de la lumière comporte un matériau émettant de la lumière ayant une capacité de transport d'électrons, un matériau hôte ayant une capacité de transport de trous, et un matériau électriquement inerte, et la concentration du matériau émettant de la lumière ayant une capacité de transport d'électrons diminue graduellement d'un côté de cathode vers un côté d'anode à travers la totalité de l'épaisseur de la couche émettant de la lumière.

**2.** Le dispositif électroluminescent organique selon la revendication 1, dans lequel la concentration du matériau électriquement inerte dans la couche émettant de la lumière diminue graduellement du côté de cathode vers le côté d'anode.

**3.** Le dispositif électroluminescent organique selon la revendication 2, dans lequel la concentration en % en masse du matériau émettant de la lumière ayant une capacité de transport d'électrons dans une région proche d'une interface côté anode de la couche émettant de la lumière varie de 0 % à 50 % par rapport à la concentration en % en masse du matériau émettant de la lumière ayant une capacité de transport d'électrons dans une région proche d'une interface côté cathode de la couche émettant de la lumière.

**4.** Le dispositif électroluminescent organique selon la revendication 3, dans lequel la concentration du matériau émettant de la lumière ayant une capacité de transport d'électrons dans la couche émettant de la lumière varie de 0 % en masse à 10 % en masse dans la région proche de l'interface côté anode.

**5.** Le dispositif électroluminescent organique selon la revendication 1, dans lequel le matériau électriquement inerte est un matériau organique ayant une différence d'énergie Eg entre l'orbitale moléculaire occupée la plus haute et l'orbitale moléculaire inoccupée la plus basse de 4,0 eV ou plus.

**6.** Le dispositif électroluminescent organique selon la revendication 5, dans lequel le matériau organique est un composé représenté par la Formule (1) suivante :

$$L\text{-}(Ar)_m$$

dans laquelle Ar représente un groupe représenté par la Formule (2) suivante, L représente un squelette de benzène trivalent ou à valence supérieure, et m représente un entier supérieur ou égal à 3 :

Formule (2)

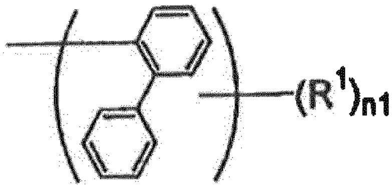

dans laquelle $R^1$ représente un substituant, et lorsque $R^1$ est présent en pluralité, chaque $R^1$ peut être identique ou différent d'un autre $R^1$, et n1 représente un entier de 0 à 9.

7. Le dispositif électroluminescent organique selon la revendication 5, dans lequel le matériau organique est un composé siloxane.

8. Le dispositif électroluminescent organique selon la revendication 1, dans lequel le matériau électriquement inerte est un matériau diélectrique inorganique.

9. Le dispositif électroluminescent organique selon la revendication 8, dans lequel le matériau diélectrique inorganique est au moins un élément choisi parmi le groupe constitué de nitrure de silicium, d'oxynitrure de silicium, d'oxyde de silicium et de carbure de silicium.

10. Le dispositif électroluminescent organique selon la revendication 1, dans lequel le matériau émettant de la lumière est un matériau émettant de la lumière phosphorescente.

11. Le dispositif électroluminescent organique selon la revendication 1, dans lequel la longueur d'onde de pic du spectre de luminescence se situe entre 430 nm et 480 nm.

FIG. 1

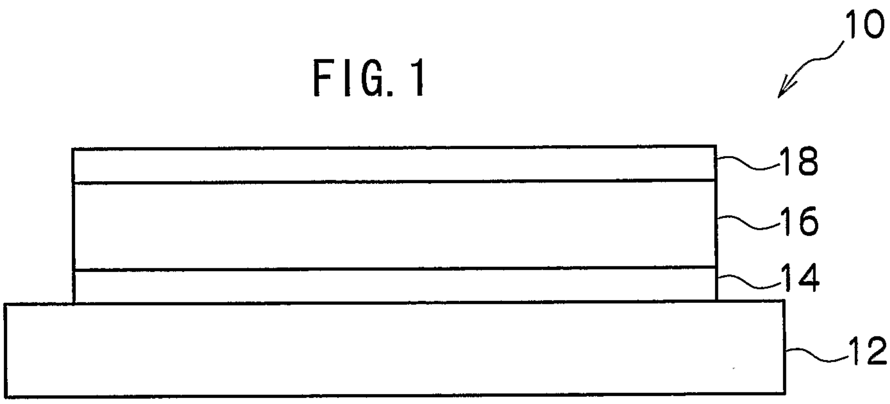

FIG. 2

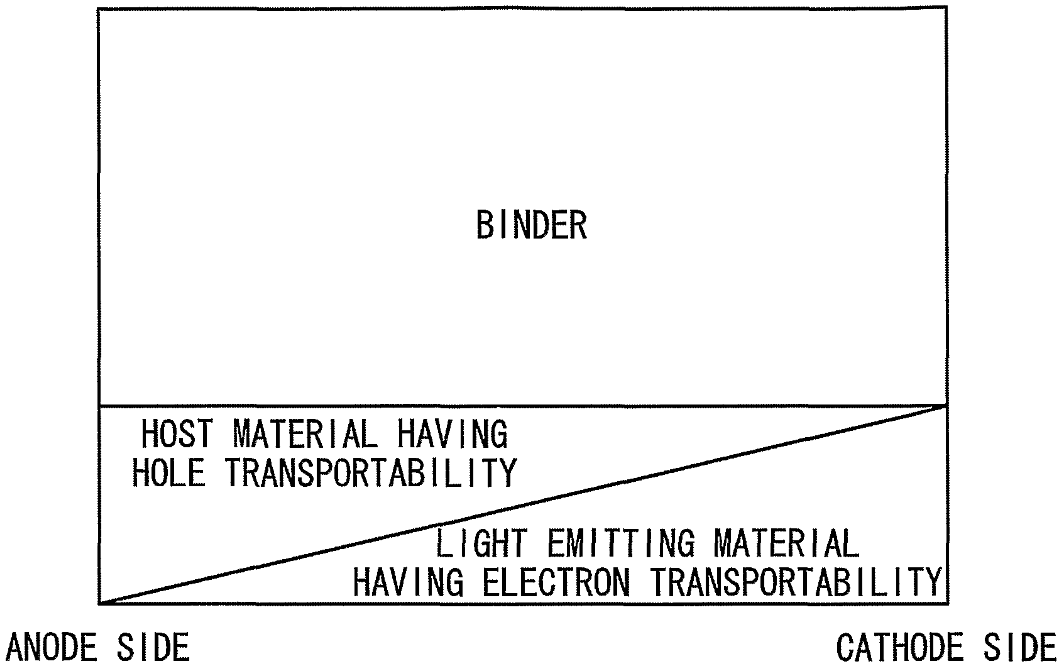
BINDER
HOST MATERIAL HAVING
HOLE TRANSPORTABILITY
LIGHT EMITTING MATERIAL
HAVING ELECTRON TRANSPORTABILITY
ANODE SIDE
CATHODE SIDE

FIG. 3

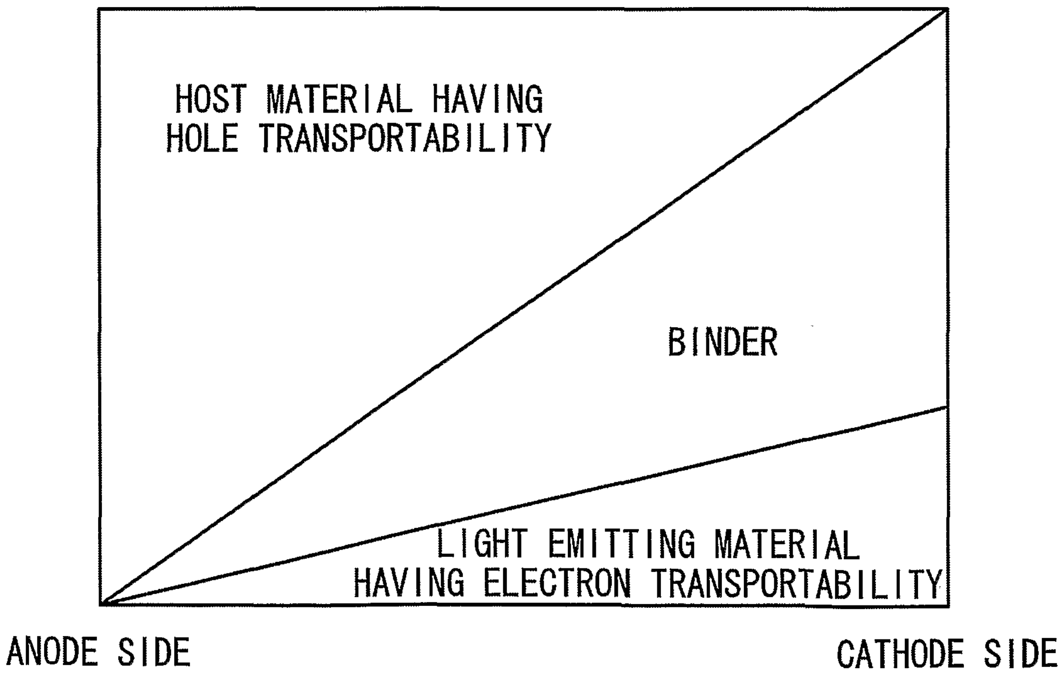
HOST MATERIAL HAVING
HOLE TRANSPORTABILITY
BINDER
LIGHT EMITTING MATERIAL
HAVING ELECTRON TRANSPORTABILITY
ANODE SIDE
CATHODE SIDE

FIG. 4A

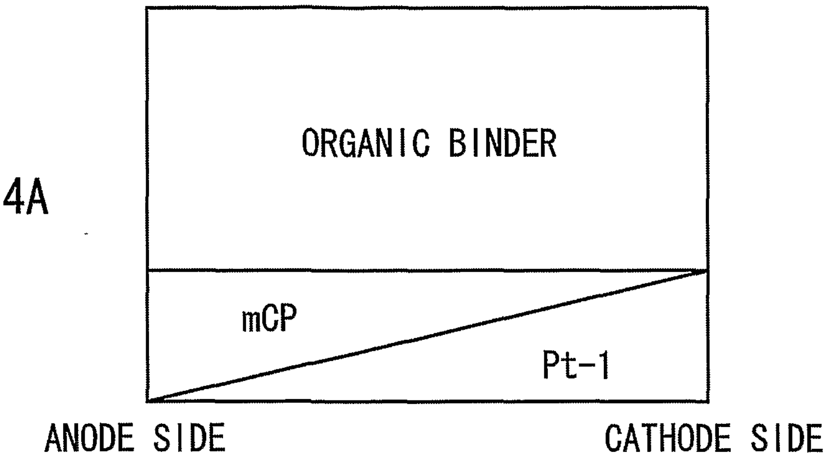


FIG. 4B

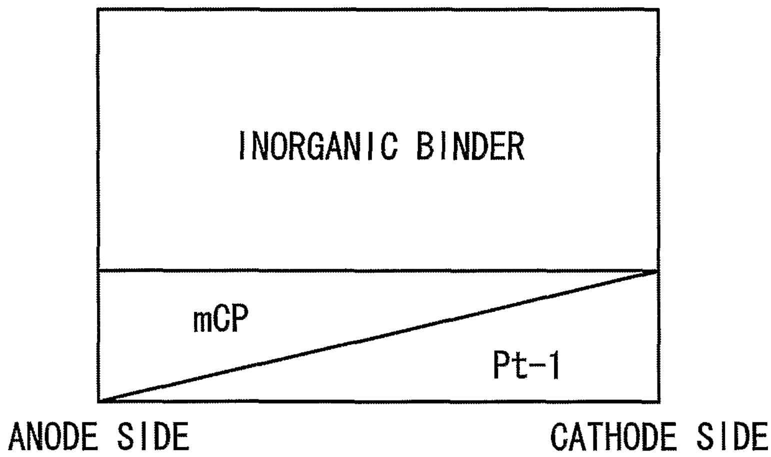


FIG. 4C

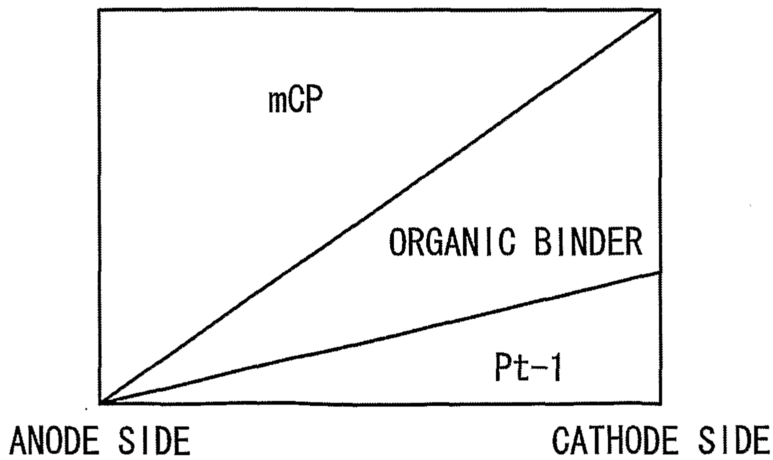

FIG. 5A

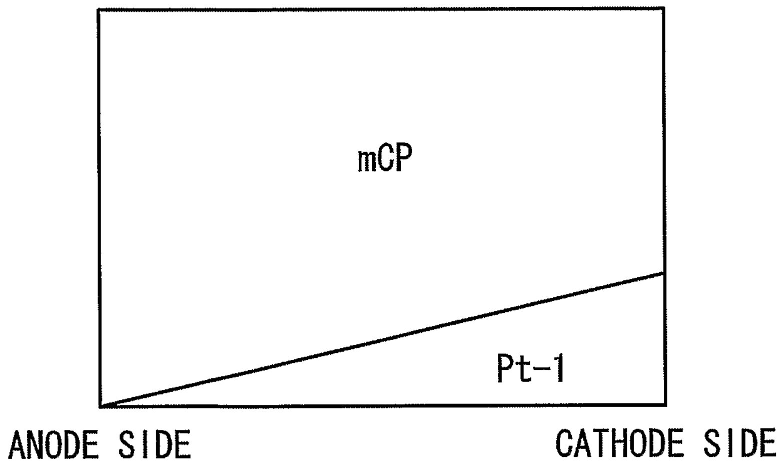


FIG. 5B

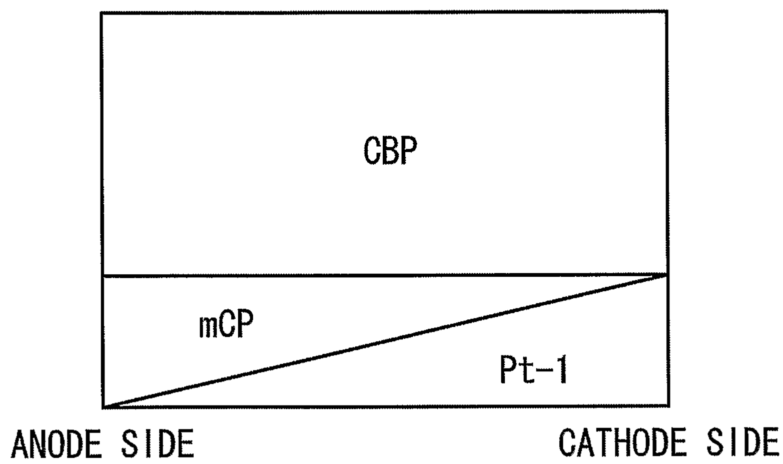


FIG. 5C

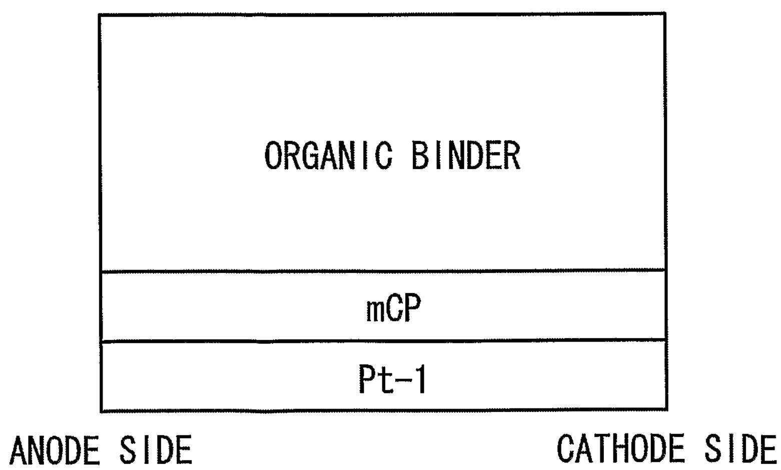

FIG. 6

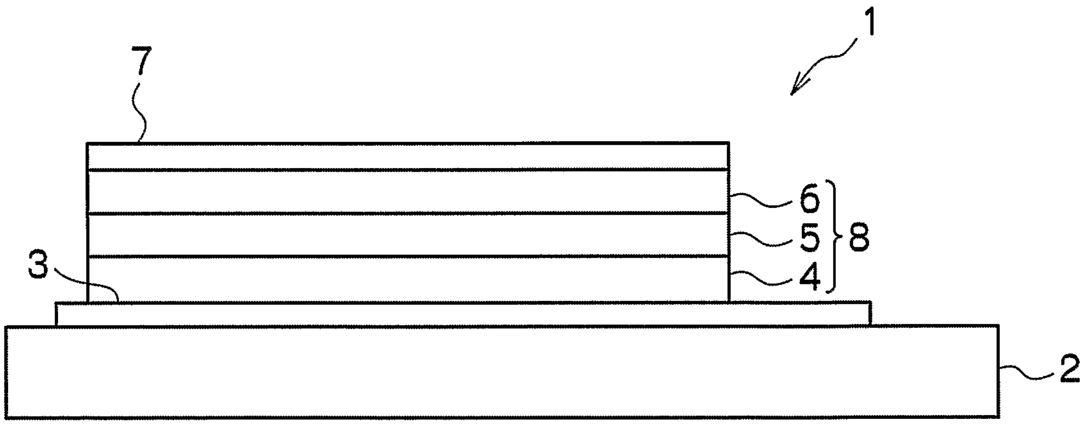

FIG. 7

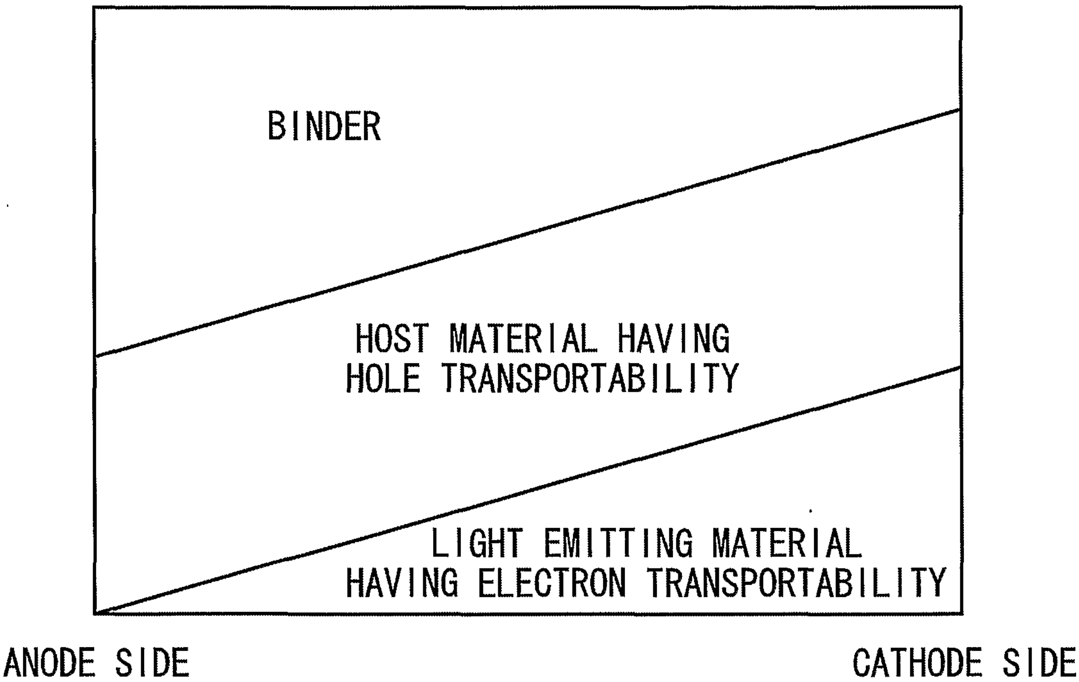
BINDER
HOST MATERIAL HAVING HOLE TRANSPORTABILITY
LIGHT EMITTING MATERIAL HAVING ELECTRON TRANSPORTABILITY
ANODE SIDE
CATHODE SIDE

## REFERENCES CITED IN THE DESCRIPTION

*This list of references cited by the applicant is for the reader's convenience only. It does not form part of the European patent document. Even though great care has been taken in compiling the references, errors or omissions cannot be excluded and the EPO disclaims all liability in this regard.*

### Patent documents cited in the description


- JP 2001155862 A
- JP 2001189193 A
- JP 2004006102 A
- JP 2002313583 A
- US 2006147615 A1
- US 6303238 B1
- US 6097147 A
- WO 0057676 A
- WO 0070655 A
- WO 0108230 A
- WO 0139234 A2
- WO 0141512 A1
- WO 0202714 A2
- WO 0215645 A1
- WO 0244189 A1
- JP 2001247859 A
- JP 2000033561 A
- JP 2002117978 A
- JP 2002225352 A
- JP 2002235076 A
- JP 2001239281 A
- JP 2002170684 A
- EP 1211257 A
- JP 2002226495 A
- JP 2002234894 A
- JP 2001298470 A
- JP 2002173674 A
- JP 2002203678 A
- JP 2002203679 A
- JP 2004357791 A
- JP 2005075340 A
- JP 2005075341 A
- JP 6212153 A
- JP 11111463 A
- JP 11251067 A
- JP 2000196140 A
- JP 2000286054 A
- JP 2000315580 A
- JP 2001102175 A
- JP 2001160493 A
- JP 2002252085 A
- JP 2002056985 A
- JP 2003157981 A
- JP 2003217862 A
- JP A A
- JP 2003229278 A
- JP 2004342614 A
- JP 2005072012 A
- JP 2005166637 A
- JP 2005209643 A
- JP 2003068468 A
- JP 2015595 A
- JP 51121172 A


### Non-patent literature cited in the description


- **YUTAKA SAWADA.** New Development of Transparent Electrode Films. CMC Publishing Co., Ltd, 1999
- **G. WILKINSON et al.** Comprehensive Coordination Chemistry. Pergamon Press, 1987
- **H. YERSIN.** Photochemistry and Photophysics of Coordination Compounds. Springer Verlag, 1987
- **YAMAMOTO AKIO.** Organometallic Chemistry - Fundamentals and Applications. Shokabo Publishing Co., Ltd, 1982